# EUROPÄISCHE PATENTSCHRIFT

(11) **EP 2 828 271 B1**
(45) Veröffentlichungstag und Bekanntmachung des Hinweises auf die Patenterteilung: **31.08.2016**
(21) Anmeldenummer: 13710390.9
(22) Anmeldetag: 15.03.2013
(51) Int. Cl.: C07F 9/09, C07F 9/12, C07F 9/32, C07F 9/36, G01N 24/08, G01R 33/58, G01R 33/46

(54) **MULTIKERNSTANDARD FÜR DIE KERNSPINRESONANZSPEKTROSKOPIE**
MULTI-ELEMENT STANDARD FOR NUCLEAR MAGNETIC RESONANCE SPECTROSCOPY
STANDARD À NOYAUX MULTIPLES POUR LA SPECTROSCOPIE PAR RÉSONANCE MAGNÉTIQUE NUCLÉAIRE

(30) Priorität: 23.03.2012 DE 102012204701
(43) Veröffentlichungstag der Anmeldung: 28.01.2015
(73) Patentinhaber: Diehl, Bernd Willi Karl-Heinz, 50678 Köln (DE)
(72) Erfinder: DIEHL, Bernd, Willi, Karl-Heinz, 50678 Köln (DE)
(74) Vertreter: Winter, Brandl, Fürniss, Hübner, Röss, Kaiser, Polte - Partnerschaft mbB
(86) Internationale Anmeldenummer: PCT/EP2013/055371
(87) Internationale Veröffentlichungsnummer: WO 2013/139698

(56) Entgegenhaltungen:
- DATABASE CA [Online] CHEMICAL ABSTRACTS SERVICE, COLUMBUS, OHIO, US; KLUMPP, EGON ET AL: "Production of new phosphoric acid ester insecticides", XP002698299, gefunden im STN Database accession no. 1990:118978 & KLUMPP, EGON ET AL: "Production of new phosphoric acid ester insecticides", MAGYAR KEMIKUSOK LAPJA , 44(9), 413-15 CODEN: MGKLAL; ISSN: 0025-0163, 1989,
- DATABASE CA [Online] CHEMICAL ABSTRACTS SERVICE, COLUMBUS, OHIO, US; METCALF, ROBERT A. ET AL: "Selective toxicity of analogs of methyl parathion", XP002698300, gefunden im STN Database accession no. 1973:488307 & METCALF R A ET AL: "Selective toxicity of analogs of methyl parathion", PESTICIDE BIOCHEMISTRY AND PHYSIOLOGY, ACADEMIC PRESS, US, Bd. 3, Nr. 2, 1. Juni 1973 (1973-06-01), Seiten 149-159, XP024867715, ISSN: 0048-3575, DOI: 10.1016/0048-3575(73)90099-0 [gefunden am 1973-06-01]
- DATABASE CA [Online] CHEMICAL ABSTRACTS SERVICE, COLUMBUS, OHIO, US; MANIARA, GRZEGORZ ET AL: "Method performance and validation for quantitative analysis by 1H and 31P agricultural chemicals", XP002698649, gefunden im STN Database accession no. 1998:697364 & GRZEGORZ MANIARA ET AL: "Method Performance and Validation for Quantitative Analysis by 1 H and 31 P NMR Spectroscopy. Applications to Analytical Standards and Agricultural Chemicals", ANALYTICAL CHEMISTRY, Bd. 70, Nr. 23, 1. Dezember 1998 (1998-12-01), Seiten 4921-4928, XP055065506, ISSN: 0003-2700, DOI: 10.1021/ac980573i

## Beschreibung

Die vorliegende Erfindung betrifft organische Verbindungen, die neben Kohlenstoffatomen und Wasserstoffatomen auch Stickstoff-, Fluor- und Phosphoratome enthalten und als ein Multikernstandard für die ¹H-, ¹³C-, ¹⁵N-, ¹⁹F- und ³¹P-Kernspinresonanzspektroskopie verwendet werden können und einen NMR-Standard, der diese Verbindungen enthält. Darüber hinaus betrifft die vorliegende Erfindung ein Kernspinresonanzspektroskopieverfahren unter Verwendung dieser Verbindungen und ein Verfahren zur Bestimmung eines Analyts mittels eines derartigen Kernspinresonanzspektroskopieverfahrens.

Die Kernspinresonanzspektroskopie, im Folgenden auch NMR-Spektroskopie genannt, ist eines der grundlegenden Verfahren zur Strukturaufklärung von organischen Verbindungen. Es basiert darauf, dass die Atomkerne einer Vielzahl von Elementen einen Kernspin verschieden von Null aufweisen und der daraus resultierende Drehimpuls bei einem angelegten externen Magnetfeld Aussagen über die chemische Umgebung des Atoms gestattet.

Atome mit einem Kernspin von Null, wie beispielsweise ²D, ¹²C oder ¹⁶O, lassen sich mittels der NMR-Spektroskopie nicht erfassen. Demgegenüber sind alle Atome mit einem Kernspin verschieden von Null der NMR-Spektroskopie zugänglich. Am vorteilhaftesten weist der Kernspin den Wert 1/2 auf, da dann lediglich zwei mögliche Eigenzustände, m = +1/2 und m = -1/2, existieren. Bei der Anwendung der NMR-Spektroskopie in der organischen Chemie kommen somit vor allem die Kerne ¹H, ¹³C, ¹⁵N, ¹⁹F, ²⁹Si, ³¹P und ⁷⁷Se in Frage.

Wird eine Probe, die Atomkerne mit einem Kernspin verschieden von Null enthält, in ein homogenes, statisches Magnetfeld gebracht, kann aufgrund der Quantentheorie der Drehimpuls der Atomkerne nur vorbestimmte Ausrichtungen zu dem angelegten Magnetfeld einnehmen. Die möglichen Ausrichtungen repräsentieren verschiedene Eigenzustände, die energetisch aufgespalten sind, so dass sich gequantelte Energieniveaus bilden. Wird nun zusätzlich zu dem angelegten statischen Magnetfeld ein hochfrequentes elektromagnetisches Wechselfeld erzeugt und entspricht dessen Energie dem Energieunterschied zweier Eigenzustände so wird ein Teil der Energie des Wechselfeldes von der Probe absorbiert, was messtechnisch erfasst und grafisch dargestellt werden kann. Im Speziellen wird hierbei die Frequenz des hochfrequenten elektromagnetischen Wechselfelds erfasst, bei der die Resonanzbedingung des Atomkerns erfüllt ist, d.h. die Kernresonanzfrequenz.

Aus den ermittelten Kernresonanzfrequenzen erhält man Informationen über den Aufbau der zu untersuchenden organischen Verbindung durch den Effekt der chemischen Verschiebung. Dieser beschreibt den Einfluss benachbarter Atome oder Gruppen auf die Elektronenhülle, die den untersuchten Atomkern umgibt und ihn gegenüber dem äußeren Magnetfeld abschirmt. Die gequantelten Energieniveaus der Eigenzustände sind abhängig von der Stärke des auf den Atomkern einwirkenden äußeren Magnetfelds und somit auch von dem Ausmaß der Abschirmung durch dessen Elektronenhülle.

Betrachtet man beispielsweise ein Wasserstoffatom so ergeben sich unterschiedliche Kernresonanzfrequenzen je nachdem ob in dessen Nähe eine elektronenziehendes oder ein die Elektronendichte erhöhendes Atom oder eine entsprechende Gruppe vorhanden ist. Darüber hinaus haben auch Anisotropie-Effekte und sterische Effekte einen Einfluss auf die chemische Verschiebung. Somit erhält man für die verschiedenen Wasserstoffatome einer organischen Verbindung unterschiedliche Kernresonanzfrequenzen, die in einem Spektrum als Signale graphisch dargestellt werden und deren Auswertung wertvolle Informationen für die Strukturaufklärung geben können. Weitere Informationen werden erhalten durch Spin-Spin-Kopplungen benachbarter Atomkerne, wodurch die im Spektrum dargestellten Signale in Gruppen aus zwei oder mehreren Signalen aufgespalten werden. Solche Spin-Spin-Kopplungen können sowohl zwischen Kernen gleichartiger als auch verschiedener Elemente auftreten.

Die Lage der Kernresonanzfrequenzen ist neben der chemischen Umgebung des Atoms unter anderem auch von der Stärke des statischen Magnetfelds und dem verwendeten Lösungsmittel abhängig und kann daher nicht auf Basis einer absoluten Skala verglichen werden. Um dennoch NMR-Spektren untereinander vergleichen zu können, wird die Lage der Kernresonanzfrequenzen gegenüber einer Referenzverbindung angegeben. In der ¹H- und ¹³C-NMR-Spektroskopie wird dafür seit langem Tetramethylsilan (TMS) verwendet. Aufgrund der Symmetrie des Moleküls weisen alle 12 Wasserstoffkerne dieselbe Resonanzfrequenz auf, die darüber hinaus durch den elektropositiven Charakter des Siliciums (starker Abschirmungseffekt) am Hochfeldrand des Spektrums liegt. Die Lage einer Resonanzfrequenz eines Wasserstoffatoms in der Probe wird in einem ¹H-NMR-Spektrum als relative Verschiebung dieser Frequenz gegenüber der Kernresonanzfrequenz der Wasserstoffatome des TMS angegeben und als chemische Verschiebung δ bezeichnet. Aufgrund der geringen Frequenzunterschiede wird dieser dimensionslose Wert in ppm (= 10⁻⁶) angegeben.

Um die Resonanzbedingungen zu erreichen kann entweder bei konstanter Feldstärke des externen Magnetfelds die Frequenz des eingestrahlten Wechselfeldes variiert werden oder kann bei konstanter Frequenz die Feldstärke variiert werden. Bei diesen Arten der Abtastung der Spektren spricht man von Continuous-Wave-Verfahren (CW-Verfahren). Heutzutage wird allerdings überwiegend die Puls-Fourier-Transform-Technik (PFT-NMR-Spektroskopie) angewendet, bei der ein Hochfrequenzimpuls auf die Probe eingestrahlt wird, dessen Frequenzband alle Kerne einer Kernsorte gleichzeitig anregt. Der anschließende Abfall der Magnetisierung, der Freie Induktionsabfall (free induction decay - FID), wird gemessen und daraus mittels der Fourier-Transformation ein Spektrum errechnet. Durch das Aufsummieren einer Vielzahl an FID's können mit dieser Technik bedeutend geringere Probenmengen analysiert werden.

Während des FID kehren die angeregten Atomkerne wieder in ihren Gleichgewichtszustand zurück, d.h. sie relaxieren. Man unterscheidet dabei zwischen zwei Relaxationsvorgängen: der longitudinalen Relaxation oder Spin-Gitter-Relaxation und der transversalen Relaxation oder Spin-Spin-Relaxation. Die Geschwindigkeit der longitudinalen Relaxation wird durch die longitudinale Relaxationszeit T₁ charakterisiert. Damit zwischen zwei Anregungsimpulsen das System wieder weitgehend seinen Gleichgewichtszustand erreicht hat wird üblicherweise eine Wartezeit von 5T₁ eingehalten. Wären nicht alle Kerne vor dem nächsten Impuls relaxiert, würden in diesem Impuls nicht alle Kerne erfasst werden, was zu falschen Signalintensitäten führen würde. Die Länge der longitudinalen Relaxationszeit T₁ ist abhängig von der chemischen Struktur des Moleküls, insbesondere von möglichen Dipol-Dipol-Wechselwirkungen mit benachbarten Atomen oder Gruppen und kann bis über 10 s betragen.

Neben der reinen Strukturaufklärung kann die NMR-Spektroskopie auch zur quantitativen Bestimmung einer zu untersuchenden Verbindung, d.h. eines Analyts, eingesetzt werden. Bei der quantitativen NMR-Spektroskopie wird aus einem Vergleich der Signalintensitäten des Analyts und einer gleichzeitig gemessenen Referenzsubstanz die in der Untersuchungslösung enthaltene Menge an Analyt berechnet. In der Regel wird als Referenzsubstanz ein interner Standard zu der Untersuchungslösung zugegeben, dessen Reinheit bekannt ist und dessen Signale sich möglichst nicht mit denen des Analyts überlagern. Die Referenzsubstanz kann auch als externer Standard verwendet werden. Im Folgenden wird eine in der NMR-Spektroskopie verwendete Referenzsubstanz auch als "Standard" bezeichnet. Dieser Standard kann als interner Standard verwendet werden, wobei er der Untersuchungslösung zugesetzt wird, oder kann auch als externer Standard verwendet werden.

In dem gemessenen NMR-Spektrum werden getrennt die Signale des Analyts und der Referenzsubstanz integriert. Dabei wird davon ausgegangen, dass jedes Atom, dessen Signale im Spektrum erscheinen, einen gleichgroßen Anteil an den Integralen der Signale beiträgt, so dass die Zahl der Atome proportional zu den Integralen, d.h. den Integralflächen, ist. Aus dem Verhältnis der Integrale und unter Berücksichtigung der Massen und Molmassen von Analyt und Referenzsubstanz und der Anzahl der Kerne deren Signale integriert wurden, kann die Stoffmenge des in der Untersuchungslösung enthaltenen Analyts berechnet werden.

Prinzipiell kann jede organische Verbindung, von der mindestens ein Signal im NMR-Spektrum quantitativ ausgewertet werden kann, als Referenzsubstanz verwendet werden. Um Lösungen mit bekannter Konzentration herstellen zu können sollte sie darüber hinaus einfach abzuwiegen sein, d.h. nicht hygroskopisch oder flüchtig sein und vorzugsweise als Feststoff vorliegen. Sie sollte chemisch stabil sein und möglichst wenige Signale im Spektrum erzeugen, die vorzugsweise getrennt von denen des Analyts erscheinen. Damit die Konzentration des Standards einfach überprüft werden kann, wäre es vorteilhaft, wenn die Referenzsubstanz ein guter Chromophor im UV/VIS ist und/oder leicht mittels Gaschromatographie erfassbar ist. Da sie in der Regel als interner Standard verwendet wird, sollte sie natürlich auch gut in den gängigen NMR-Lösungsmitteln löslich sein.

Viele der üblicherweise für die quantitative NMR-Spektroskopie verwendeten Referenzsubstanzen, die im ¹H-NMR-Spektrum ein Singulett-Signal erzeugen, wie beispielsweise Maleinsäure und Tetrachlornitrobenzol (TCNB) 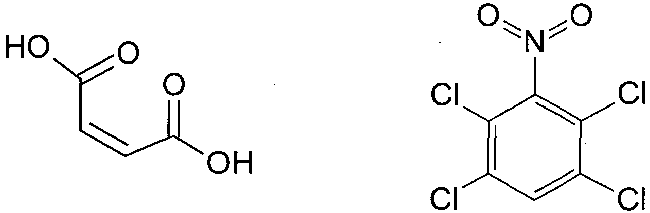 weisen lange Spin-Gitter-Relaxationszeiten auf. Im Fall von TCNB ist T₁ größer als 10 s.

Maniara, Grzegorz et al. in "Method Performance and Validation for Quantitative Analysis by 1H and 31P NMR Spectroscopy. Applications to Analytical Standards and Agricultural Chemicals", Analytical Chemistry, Bd. 70, Nr. 23, 1. Dezember 1998, Seiten 4921-4928, offenbaren einen unsubstituierten Phosphorsäuretriphenylester (O=P(OPh)₃) als internen Standard für die quantitative ¹H und ³¹P NMR-Spektroskopie.

Phosphorsäurephenyldimethylester mit -NO₂ und -CF₃ Substituenten am Phenylrest zur Verwendung als Pestizide und Insektizide werden offenbart von Klumpp, Egon et al. in "Production of new phosphoric acid ester insecticides", Magyar Kemikusok Lapja, 44(9), Seiten 413-15 CODEN: MGKLAL; ISSN: 0025-0163, 1989, und von Metcalf, Robert A. et al. in "Selective toxicity of analogs of methyl parathion", Pesticide Biochemistry And Physiology, Academic Press, US, Bd. 3, Nr. 2, 1. Juni 1973, Seiten 149-159.

Damit bei der Analyse geringer Probemengen und der dadurch notwendigen Aufsummierung einer großen Anzahl an FID's die verwendete Referenzsubstanz nicht limitierend ist, sollte sie eine kurze Spin-Gitter-Relaxationszeit aufweisen. Diese sollte vorzugsweise bei 5 s oder darunter liegen.

Wie einleitend erwähnt, werden in der NMR-Spektroskopie neben ¹H und ¹³C auch die Kerne ¹⁵N, ¹⁹F und ³¹P genutzt. Die bisher bekannten und vor allem in der quantitativen NMR-Spektroskopie verwendeten Referenzsubstanzen sind nur für die spektroskopische Betrachtung einer oder maximal zwei Kernarten geeignet. Soll bei derselben Probe auch eine andere Kernart gemessen werden, so sind dazu bisher andere Standards zuzusetzen, was vor allem bei der quantitativen NMR-Spektroskopie aufwändig ist, da genau definierte Standardlösungen hergestellt und genau zudosiert werden müssen. Diese weiteren Standardlösungen müssen darüber hinaus auch regelmäßig auf ihre Reinheit kontrolliert werden, was einen zusätzlichen Aufwand darstellt.

Es ist daher die Aufgabe der vorliegenden Erfindung, Referenzsubstanzen zur Verfügung zu stellen, mit denen bei der ¹H-, ¹³C-, ¹⁵N-, ¹⁹F- und ³¹P-NMR-Spektroskopie, insbesondere der quantitativen NMR-Spektroskopie, die oben beschriebenen Nachteile vermieden werden können ohne dass die Genauigkeit des Verfahrens verschlechtert ist. Mit diesen Referenzsubstanzen sollen darüber hinaus auch geringe Mengen verschiedenster Analyten untersucht werden können, ohne dass dabei die Gefahr besteht, dass unterschiedliche Spin-Gitter-Relaxationszeiten die Ergebnisse verfälschen. Aufgabe der vorliegenden Erfindung ist es ferner, ein quantitatives Kernspinresonanzspektroskopieverfahren für diese Kerne bzw. ein Verfahren zur quantitativen Bestimmung eines Analyts mittels eines derartigen Kernspinresonanzspektroskopieverfahrens bereitzustellen.

In Bezug auf die Bereitstellung geeigneter Referenzsubstanzen wird die obige Aufgabe gemäß der vorliegenden Erfindung gelöst durch:
A) Die Verwendung einer der Verbindungen der Formel (1) oder (2) 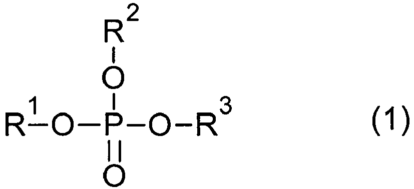 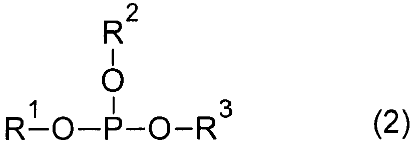
   wobei R¹ ein Phenylrest oder Benzylrest ist, dessen Benzolring folgende Substituenten aufweist:
      mindestens einen -CF₃-Substituenten,
      mindestens einen stickstoffhaltigen Substituenten ausgewählt aus -NO₂ und -NR⁴R⁵, wobei R⁴ und R⁵ unabhängig voneinander ausgewählt sind aus H, CH₃ und CH₂CH₃,
      gegebenenfalls einen oder zwei Substituenten ausgewählt aus Cl, Br, I, -CH₃ und -C(=O)OR⁶, wobei R⁶ ausgewählt ist aus H, CH₃ und CH₂CH₃, und mindestens ein Wasserstoffatom, wobei mindestens eines der Wasserstoffatome ortho zu mindestens einem Substituenten steht ausgewählt aus -NO₂ und -C(=O)OR⁶, und
   wobei R² und R³ gleich R¹ sind oder unabhängig voneinander ausgewählt sind aus H, CH₃ und CH₂CH₃,
   als Standard bei der ¹H-, ¹³C-, ¹⁵N-, ¹⁹F- oder ³¹P-Kernspinresonanzspektroskopie,
B) eine Verbindung der obigen Formel (1) oder (2) oder der Formel (9) mit Ausnahme der folgenden Verbindungen: 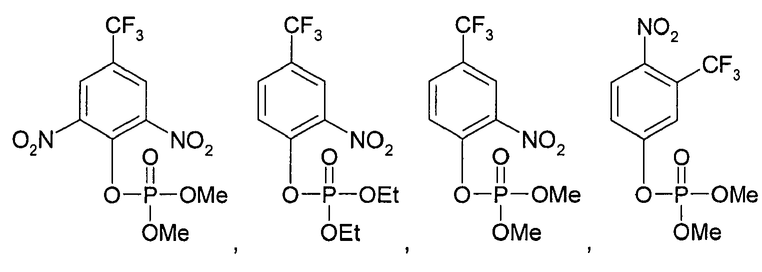 und 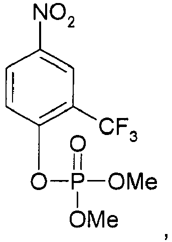 bzw.
C) einen NMR-Standard, der eine Verbindung der obigen Formel (1) oder (2) oder der Formel (9) enthält mit Ausnahme der folgenden Verbindungen: 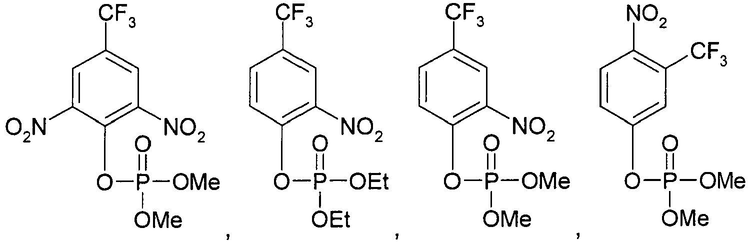 und

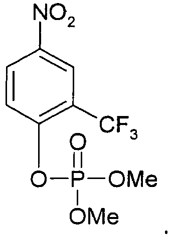

Die vorliegende Erfindung stellt ferner ein Kernspinresonanzspektroskopieverfahren zur Verfügung, bei dem die Kernspinresonanz von einem der Atome ¹H, ¹³C, 15N, ¹⁹F oder ³¹P erfasst wird, was dadurch gekennzeichnet ist, dass als Standard eine Verbindung der obigen Formel (1) oder (2) verwendet wird.

Schließlich stellt die vorliegende Erfindung ein Verfahren zur qualitativen und/oder quantitativen Bestimmung eines Analyts mittels der ¹H-, ¹³C-, ¹⁵N-, ¹⁹F- oder ³¹P-Kernspinresonanzspektroskopie zur Verfügung, das dadurch gekennzeichnet ist, dass als Standard eine Verbindung der obigen Formel (1) oder (2) verwendet wird.

Die Verbindungen der Formel (1) und (2) sind Phosphorsäure- bzw. Phosphonsäureester und enthalten neben Kohlenstoffatomen und Wasserstoffatomen auch Stickstoff-, Fluor- und Phosphoratome und können daher als Multikernstandards für die ¹H-, ¹³C-, ¹⁵N-, ¹⁹F- oder ³¹P-Kernspinresonanzspektroskopie verwendet werden. Damit entfällt die Herstellung, Bereithaltung, Kontrolle mehrerer Standards bzw. Standardlösungen und die Zugabe mehrere Standards zu einer Probe, wenn bei dieser mehr als eine Kernart NMR-spektroskopisch untersucht werden soll.

Vorzugsweise werden die erfindungsgemäßen Verbindungen als interner Standard verwendet.

Die Verwendung einer der erfindungsgemäßen Verbindungen als Standard in der NMR-Spektroskopie bedeutet, dass die Verbindung der Untersuchungslösung, die die zu untersuchende Verbindung (den Analyten) enthält, zugegeben und darin aufgelöst wird und die mit dem Standard versetzte Untersuchungslösung dann in einem NMR-Spektrometer vermessen wird.

Dadurch dass die Verbindungen der Formel (1) und (2) Stickstoff-, Fluor- und Phosphor-haltige Gruppen umfassen, sind sie für eine Reihe von Quantifizierungsverfahren zugänglich, mit denen die Reinheit des Standards einfach bestimmt bzw. überprüft werden können.

Bei den Verbindungen der Formel (1) und (2) steht mindestens eines der Wasserstoffatome am Benzolring ortho zu mindestens einem Substituenten ausgewählt aus -NO₂ und -C(=O)OR⁶. Durch den Einfluss dieser benachbarten und stark elektronenziehenden Gruppen erscheint in einem ¹H-NMR-Spektrum das Signal dieses Wasserstoffatoms bei niedrigem Feld, vorzugsweise bei δ ≥ 8. Die Wahrscheinlichkeit dass dieses Signal mit Signalen des Analyts überlappt ist daher gering. Vorzugsweise befindet sich in ortho-Stellung zu diesem Wasserstoffatom kein weiteres Wasserstoffatom. Dadurch wird eine Spin-Spin-Kopplung vermieden und das aromatische Wasserstoffatom wird im Spektrum als Singulett repräsentiert.

Ist als elektronenziehende Gruppen ortho zu dem Wasserstoffatom die Gruppe -C(=O)OR⁶ vorhanden, so ist R⁶ ausgewählt aus H, CH₃ und CH₂CH₃, um wenige zusätzliche Signale im Spektrum zu erzeugen. Bevorzugt ist R⁶ gleich H oder CH₃.

Von den beiden elektronenziehenden Gruppen -NO₂ und -C(=O)OR⁶ ist die NO₂-Gruppe bevorzugt, da sie keine zusätzlichen Signale im Spektrum erzeugt.

Das Stickstoffatom kann in der erfindungsgemäßen Multikernstandardverbindung als NO₂-Gruppe oder Aminogruppe enthalten sein, wobei das Stickstoffatom dabei direkt an den Benzolring gebunden ist. Bei einer an den Benzolring gebundenen Aminogruppe sind die beiden Reste R⁴ und R⁵ unabhängig voneinander gleich H, CH₃ oder CH₂CH₃. wobei H und CH₃ bevorzugt sind.

Von den beiden möglichen stickstoffhaltigen Gruppen ist die direkt an den Benzolring gebundene NO₂-Gruppe bevorzugt, da damit zum Einen keine zusätzlichen Signale in ¹H- bzw. ¹³C-NMR-Spektren erzeugt werden und andererseits ein zu der NO₂-Gruppe ortho stehendes Wasserstoffatom in einem ¹H-NMR-Spektrum bei einer hohen chemischen Verschiebungen erscheint.

Die in der vorliegenden Anmeldung genannten Werte δ der chemischen Verschiebung sind definiert in Bezug auf die chemische Verschiebung der Wasserstoffatome bzw. Kohlenstoffatome von Tetramethylsilan, welche auf jeweils 0 ppm festgelegt sind.

Der substituierte Benzolring in der Verbindung der Formel (1) oder (2) kann in Form eines Phenylrests direkt oder in Form eines Benzylrests über eine Methylengruppe (CH₂-Gruppe) an das Sauerstoffatom der Phosphorsäure- oder Phosphonsäuregruppe gebunden sein. Die Anbindung über die Methylengruppe bewirkt eine Dipol-Dipol-Wechselwirkung mit dem Phosphoratom, wodurch dessen Relaxationszeit T₁ verringert ist und somit kürzere Abstände zwischen zwei Anregungsimpulsen ermöglicht werden.

Die drei Reste R¹, R² und R³ können gleich oder verschieden sein. Wenn R² und R³ gleich R¹ sind, erscheinen keine zusätzlichen Signale im Spektrum. Sind R² und R³ verschieden von R¹, sind sie ausgewählt aus H, CH₃ und CH₂CH₃, so dass nur wenige zusätzliche Signale in ¹H- bzw. ¹³C-NMR-Spektren erzeugt werden. Vorzugsweise sind R² und R³ dann gleich H oder CH₃.

Von den Verbindungen der Formeln (1) und (2) sind die der Formel (1) bevorzugt.

Bevorzugt weist die Verbindung der Formeln (1) oder (2) ein oder zwei an den Benzolring gebundene Wasserstoffatome auf.

Bei einer bevorzugten Ausführungsform der Erfindung sind zwei Wasserstoffatome am Benzolring gebunden. Durch eine geeignete Anordnung der beiden Wasserstoffatome und der weiteren Substituenten am Ring, wird es möglich, dass die beiden Wasserstoffatome unterschiedliche Spin-Gitter-Relaxationszeiten aufweisen. Vorzugsweise sind die beiden Wasserstoffatom nicht benachbart, um eine Aufspaltung ihrer Signale im ¹H-NMR-Spektrum zu vermeiden. Besonders bevorzugt stehen die beiden Wasserstoffatom meta zueinander.

Bei den Verbindungen der Formeln (1) und (2) ist ferner vorzugsweise mindestens ein Wasserstoffatom am Benzolring ortho zu mindestens einem CF₃-Substituenten oder CH₃-Substituenten angeordnet. Durch die zu dem aromatischen Wasserstoffatom benachbarte CF₃- oder CH₃-Gruppe findet eine Dipol-Dipol-Wechselwirkung statt, wodurch sich die Spin-Gitter-Relaxationszeit des Wasserstoffatoms deutlich verkürzt. So beträgt bei der Verbindung Tetrachlornitrobenzol die Spin-Gitter-Relaxationszeit T₁ des aromatischen Wasserstoffatoms mehr als 10 s. Wird eines der zum Wasserstoffatom benachbarten Chloratome durch eine CF₃-Grupper ersetzt, so verringert sich T₁ auf ca. 5 s. Damit geht eine bedeutende Zeitersparnis einher, wenn eine hohe Anzahl an FID's aufsummiert werden soll. Sind in ortho-Stellung zu dem aromatischen Wasserstoffatom zwei der oben genannten Substituenten angeordnet, so kann die Spin-Gitter-Relaxationszeit des Wasserstoffatoms noch weiter verringert werden und Werte von bis zu 2 s oder weniger erreichen.

Von den beiden genannten Gruppen -CH₃ und -CF₃ ist die CF₃-Gruppe bevorzugt, da sie keine zusätzlichen Signale in einem ¹H- bzw. ¹³C-NMR-Spektrum erzeugt.

Vorzugsweise enthalten die erfindungsgemäßen Verbindungen der Formel (1) und (2) mindestens ein Wasserstoffatoms, dessen Relaxationszeit maximal 5 s beträgt und dessen Signal in einem ¹H-NMR-Spektrum bei einer chemischen Verschiebung von mindestens 8 ppm erscheint.

Eine bevorzugte Ausführungsform stellen auch Verbindungen der Formeln (1) und (2) dar, bei denen zwei am Benzolkern gebundene Wasserstoffatome ortho zu mindestens einem CF₃-Substituenten oder CH₃-Substituenten angeordnet sind. Vorzugsweise steht bei diesen Verbindungen eines der beiden Wasserstoffatome ortho zu zwei der genannten Substituenten, so dass eine Verbindung erhalten wird, deren beide aromatischen Wasserstoffatome geringe Spin-Gitter-Relaxationszeiten von vorzugsweise kleiner gleich 5 s aufweisen und eines der beiden Wasserstoffatome eine noch geringere Spin-Gitter-Relaxationszeit von vorzugsweise 2 s oder weniger aufweist. Wird eine derartige Verbindung bei der quantitativen NMR-Spektroskopie als Standard verwendet, so steht damit ein System-Suitability-Test zur Verfügung, der anzeigt, ob die Integrale der gemessenen Signale korrekt erfasst wurden. Dieser System-Suitability-Test wird später ausführlicher erläutert.

In einer weiteren bevorzugten Ausführungsform weisen die Verbindungen der Formeln (1) und (2) zwei oder mehr Wasserstoffatome am Benzolkern auf und es stehen mindestens zwei dieser Wasserstoffatome ortho zu mindestens einem Substituenten, ausgewählt aus -NO₂ und -C(=O)OR₆. Dadurch erscheinen im ¹H-NMR-Spektrum die Signale der beiden ortho zu den elektronenziehenden Gruppen stehenden Wasserstoffatom bei hohen chemischen Verschiebungen, vorzugsweise bei δ ≥ 8 und somit ist die Wahrscheinlichkeit der Überlappung mit Signalen des Analyts gering. Vorzugsweise sind diese beiden Wasserstoffatome nicht benachbart, d.h. sie stehen meta oder para, vorzugsweise meta, zueinander, so dass im ¹H-NMR-Spektrum zwei Singuletts erhalten werden.

Wenn darüber hinaus eines der beiden aromatischen Wasserstoffatome ortho zu einer CF₃-Gruppe oder CH₃-Gruppe steht ist dessen Spin-Gitter-Relaxationszeit T₁ deutlich verringert gegenüber der des anderen Wasserstoffatoms am Benzolring. Hierbei unterscheiden sich die Spin-Gitter-Relaxationszeiten T₁ der beiden Wasserstoffatome um vorzugsweise mindestens 3 s, weiter bevorzugt, um mindestens 5 s und besonders bevorzugt um mindestens 7 s. Wie bereits zuvor erwähnt, beträgt die chemische Verschiebung dieser beiden Wasserstoffatome am Benzolring in einem ¹H-NMR-Spektrum vorzugsweise mindestens 8 ppm.

Werden bei der quantitativen NMR-Spektroskopie die Integrale von Signalen verwendet, deren Kerne deutlich unterschiedliche Spin-Gitter-Relaxationszeiten T₁ aufweisen, so werden falsche Ergebnisse erhalten, wenn zwischen zwei Anregungsimpulsen keine ausreichende Zeit gewartet wird, damit überwiegend alle Kerne wieder relaxiert sind. Wird die zuvor beschriebene Verbindung als Standard in der quantitativen NMR-Spektroskopie verwendet, so erscheinen im ¹H-NMR-Spektrum bei hoher chemischer Verschiebung zwei Singuletts, die von den beiden nicht benachbart zueinander angeordneten aromatischen Wasserstoffatomen herrühren. Wäre die Wartezeit zwischen zwei aufeinanderfolgende Anregungsimpulse zu gering, so dass das Wasserstoffatom mit der längeren Spin-Gitter-Relaxationszeit nicht ausreichend relaxiert ist, würden diese beiden Signale unterschiedliche Intensitäten (Integrale) aufweisen. Somit kann bei gleichen Intensitäten der beiden Singuletts davon ausgegangen werden, dass die Messung nicht durch zu geringe Wartezeiten zwischen zwei Anregungsimpulsen verfälscht ist.

Ein derartiger Standard erlaubt damit eine hohe Sicherheit bei der quantitativen NMR-Spektroskopie von Verbindungen deren Kerne stark unterschiedliche Spin-Gitter-Relaxationszeiten T₁ aufzeigen. Weisen die beiden aromatischen Wasserstoffatome im erfindungsgemäßen Standard Spin-Gitter-Relaxationszeiten von beispielsweise 4 s und 10 s auf und haben deren Signale im Spektrum gleiche Intensitäten, so ist sichergestellt, dass auch vom Analyt alle Kerne mit Spin-Gitter-Relaxationszeiten von bis zu 10 s quantitativ korrekt erfasst wurden. Werden derartige Verbindungen in der NMR-Spektroskopie als Standard verwendet, wird damit ein System-Suitability-Test (Systemselbsttest) integriert, der anzeigt, ob bei den verwendeten Wartezeiten zwischen zwei aufeinanderfolgenden Anregungsimpulsen eine korrekte Erfassung der Signalintensitäten stattfand.

In einer bevorzugten Ausführungsform der Verbindungen der Formeln (1) und (2) trägt der Benzolring nur ein Wasserstoffatom. Dadurch wird die Anzahl möglicher Signale durch den Standard in einem ¹H-NMR-Spektrum gering gehalten, so dass weniger Überlappungen mit Signalen des Analyts auftreten können. Vorzugsweise steht dieses eine Wasserstoffatom am Benzolring ortho zu mindestens einem CF₃-Substituenten oder CH₃-Substituenten, weiter bevorzugt ortho zu mindestens einem CF₃-Substituenten, so das die Spin-Gitter-Relaxationszeit des Wasserstoffatoms verringert ist, vorzugsweise auf 5 s oder weniger.

Von der vorliegenden Erfindung ist auch ein NMR-Standard umfasst, der eine der oben genannten erfindungsgemäßen Verbindungen enthält. Dieser Standard kann ein Feststoff oder eine Lösung in einem geeigneten Lösungsmittel sein. Der erfindungsgemäße Standard kann sowohl für qualitative als auch quantitative NMR-Messungen verwendet werden. Der erfindungsgemäße NMR-Standard kann sowohl als interner als auch externer Standard verwendet werden.

Darüber hinaus umfasst die vorliegende Erfindung auch die Verwendung einer oder mehrere der oben genannten erfindungsgemäßen Verbindungen als Standard bei der ¹H-, ¹³C-, ¹⁵N-, ¹⁹F- oder ³¹P-Kernspinresonanzspektroskopie. Besonders bevorzugt ist die Verwendung in der quantitativen NMR-Spektroskopie.

Die erfindungsgemäße Verwendung als interner Standard in der NMR-Spektroskopie umfasst die Zugabe einer der erfindungsgemäßen Verbindungen zu der Untersuchungslösung, die die zu untersuchende Verbindung (den Analyt) enthält, das Auflösen der zugegebenen Verbindung in der Untersuchungslösung und das Vermessen der mit dem Standard versetzten Untersuchungslösung in einem NMR-Spektrometer.

Umfasst von der vorliegenden Erfindung ist auch ein Kernspinresonanzspektroskopieverfahren, bei dem die Kernspinresonanz von einem der Atome ¹H, ¹³C, ¹⁵N, ¹⁹F oder ³¹P erfasst wird und bei dem als Standard eine oder mehrere der oben genannten erfindungsgemäßen Verbindungen verwendet wird bzw. werden. Besonders bevorzugt ist das NMR-Verfahren ein quantitatives NMR-Verfahren.

Schließlich umfasst die vorliegende Erfindung auch ein Verfahren zur Bestimmung eines Analyts mittels der ¹H-, ¹³C-, ¹⁵N-, ¹⁹F- oder ³¹P-Kernspinresonanzspektroskopie, bei dem als Standard eine oder mehrere der oben genannten erfindungsgemäßen Verbindungen verwendet wird bzw. werden. Die Bestimmung mittels des erfindungsgemäßen Verfahrens kann eine qualitative und/oder quantitative Bestimmung sein.

Im Folgenden werden besonders bevorzugte Verbindungen gemäß der vorliegenden Erfindung aufgezeigt.

Verbindungen der Formel (3): 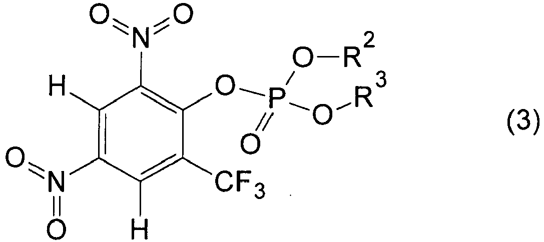 wobei die Reste R² und R³ unabhängig voneinander ausgewählt sind aus dem in der Formel (3) dargestellten Phenylrest, H, CH₃ und CH₂-CH₃, vorzugsweise aus dem Phenylrest, H und CH₃.

Bevorzugte Vertreter der Verbindungen der Formel (3) sind die Verbindungen der folgenden Formeln:

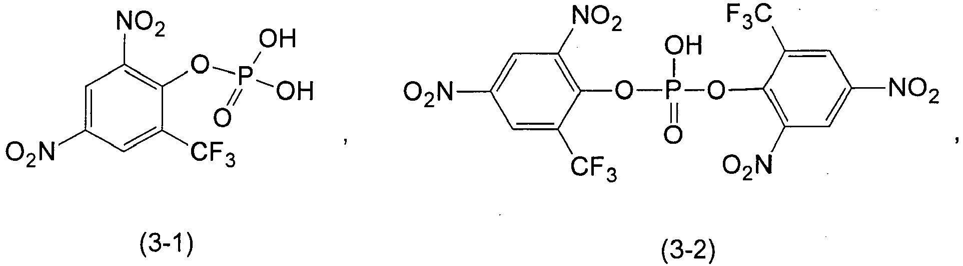

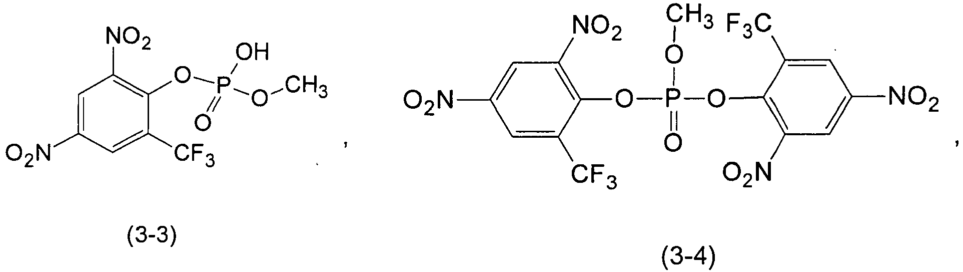

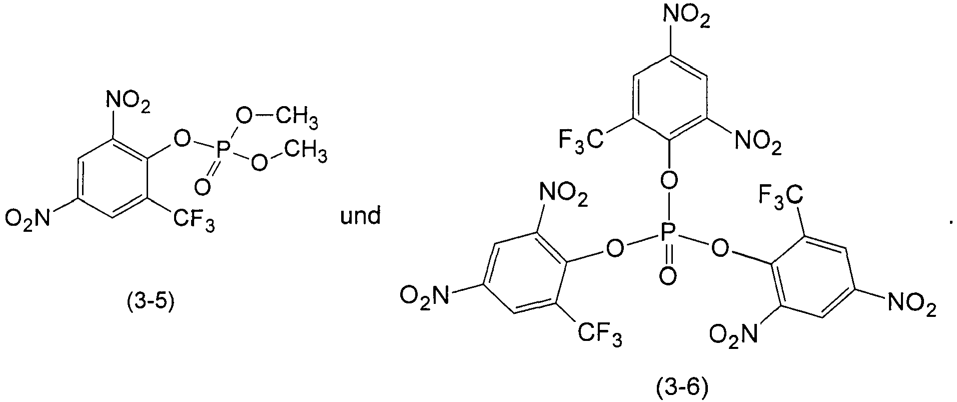

Bei den Verbindungen der Formel (3) weisen beide aromatischen Wasserstoffatome eine hohe chemische Verschiebung auf, wobei das Wasserstoffatom zwischen den beiden NO₂-Gruppen noch weiter in Richtung eines niedrigen Feldes verschoben ist. Somit werden in einem ¹H-NMR-Spektrum zwei Singuletts erhalten. Darüber hinaus zeigt das Wasserstoffatom benachbart zu der CF₃-Gruppe eine Spin-Gitter-Relaxationszeit T₁ von weniger als 5 s auf während das zwischen den beiden NO₂-Gruppen eine relativ hohe Spin-Gitter-Relaxationszeit von mehr als ungefähr 10 s aufzeigt. Bei Verwendung einer Verbindung der Formel (3) als Standard bei der quantitativen NMR-Spektroskopie ist daher ein System-Suitability-Test (Systemselbsttest) möglich, da bei identischen Signalen (Integralen) der beiden Singuletts der Wasserstoffatom am Benzolring sichergestellt ist, dass alle Kerne mit Spin-Gitter-Relaxationszeiten von bis zu 10 s in der Untersuchungslösung korrekt erfasst wurden.

Zudem können diese Verbindungen als Standard bei der ¹H-, ¹³C-, ¹⁵N-, ¹⁹F- und ³¹P-Kernspinresonanzspektroskopie verwendet werden.

Verbindungen der Formel (4): 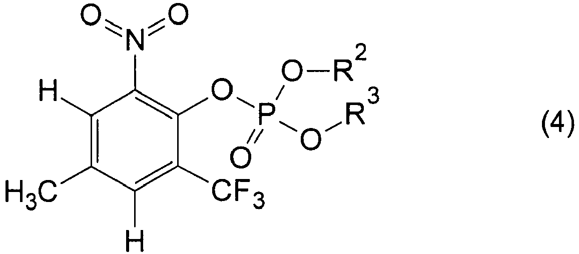 wobei die Reste R² und R³ unabhängig voneinander ausgewählt sind aus dem in der Formel (4) dargestellten Phenylrest, H, CH₃ und CH₂-CH₃, vorzugsweise aus dem Phenylrest, H und CH₃.

Bevorzugte Vertreter der Verbindungen der Formel (4) sind die Verbindungen der folgenden Formeln:

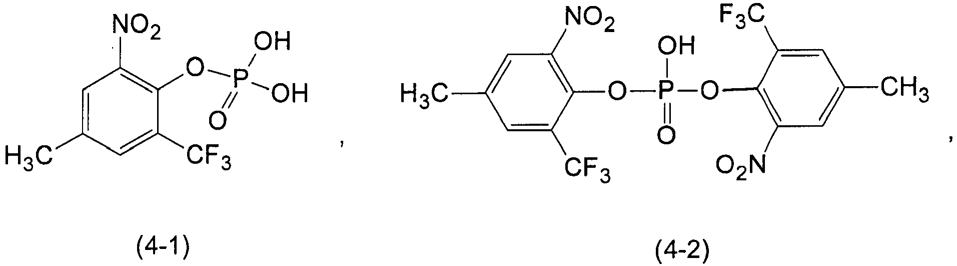

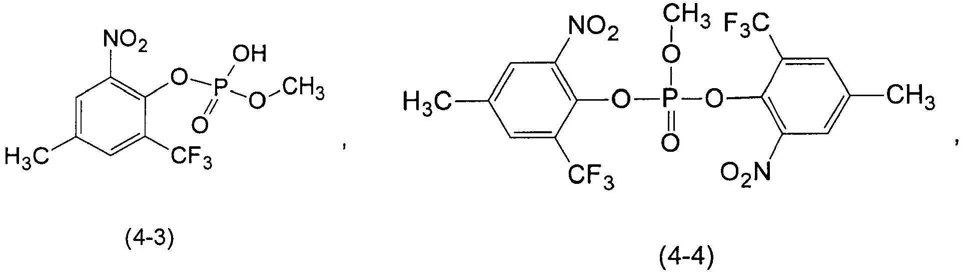

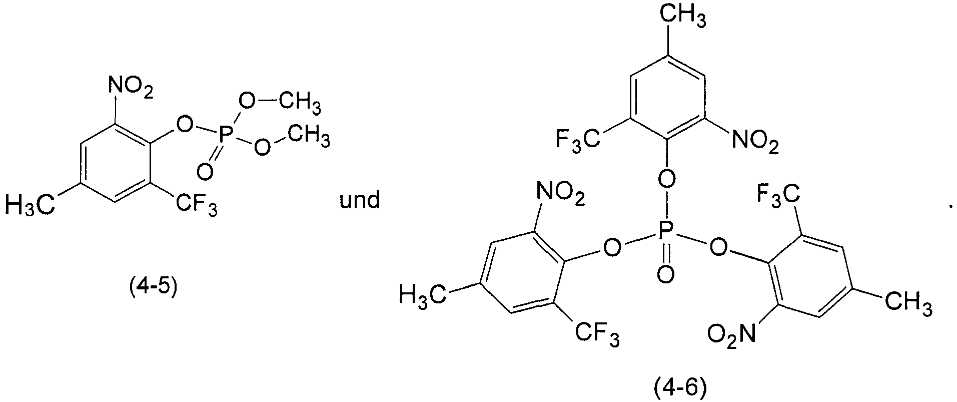

Bei den Verbindungen der Formel (4) zeigt das aromatische Wasserstoffatom zwischen der NO₂-Gruppe und der CH₃-Gruppe eine Spin-Gitter-Relaxationszeit von weniger als ungefähr 5 s auf, während das aromatische Wasserstoffatom zwischen der CH₃-Gruppe und der CF₃-Gruppe aufgrund der Dipol-Dipol-Wechselwirkungen mit beiden Gruppen eine noch geringere Spin-Gitter-Relaxationszeit von ungefähr 2 s aufzeigt. Unter Verwendung dieser Verbindungen als Standard bei der quantitativen NMR-Spektroskopie ist eine korrekte Erfassung aller Kerne in der Untersuchungslösung sichergestellt, die Spin-Gitter-Relaxationszeiten von 2 bis 5 s aufzeigen.

Darüber hinaus verringert die CF₃-Gruppe benachbart zu der Phosphorsäuregruppe die Spin-Gitter-Relaxationszeit des Phosphorkerns.

Zudem können diese Verbindungen als Standard bei der ¹H-, ¹³C-, ¹⁵N-, ¹⁹F- und ³¹P-Kernspinresonanzspektroskopie verwendet werden.

Verbindungen der Formel (5): 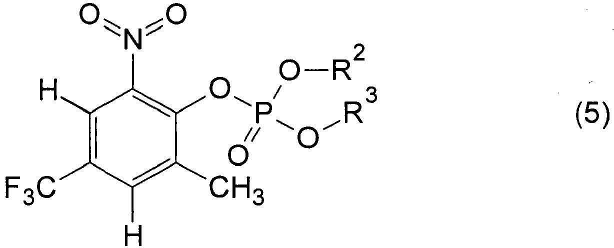 wobei die Reste R² und R³ unabhängig voneinander ausgewählt sind aus dem in der Formel (5) dargestellten Phenylrest, H, CH₃ und CH₂-CH₃, vorzugsweise aus dem Phenylrest, H und CH₃.

Bevorzugte Vertreter der Verbindungen der Formel (5) sind die Verbindungen der folgenden Formeln:

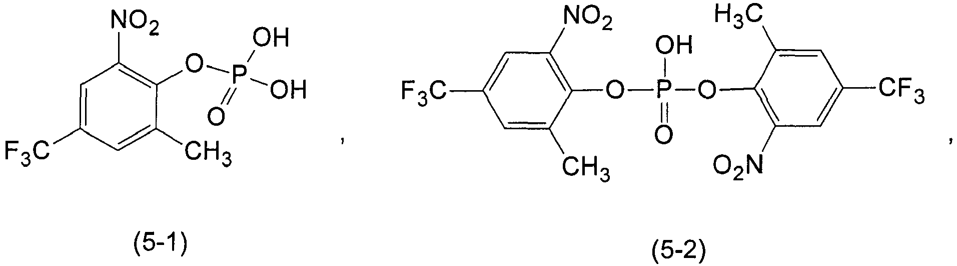

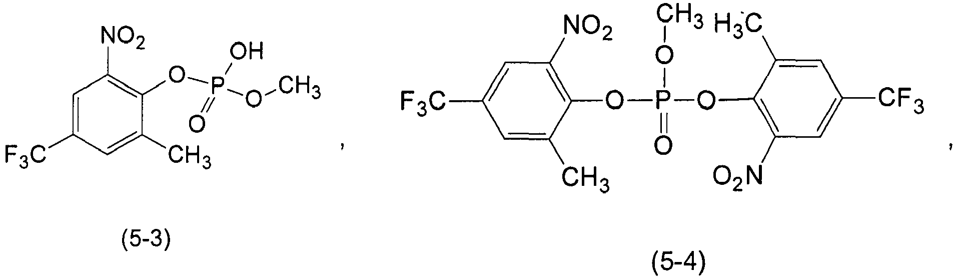

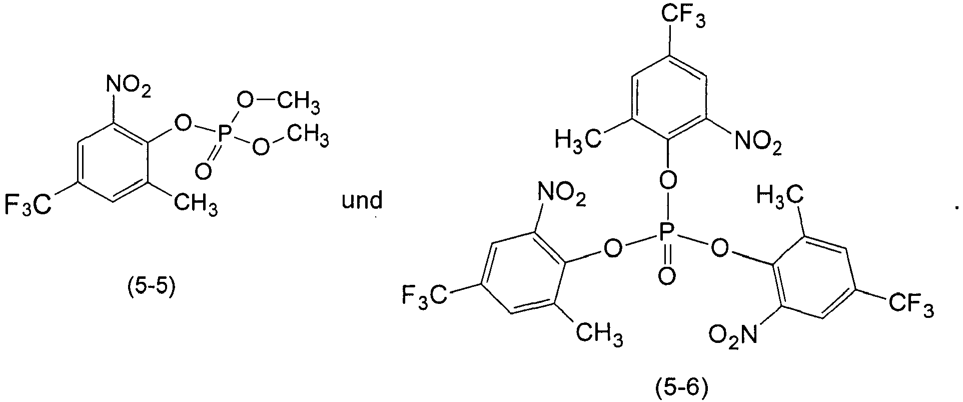

Die Eigenschaften der Verbindungen der Formel (5) sind vergleichbar mit denen der Formel (4).

Verbindungen der Formel (6): 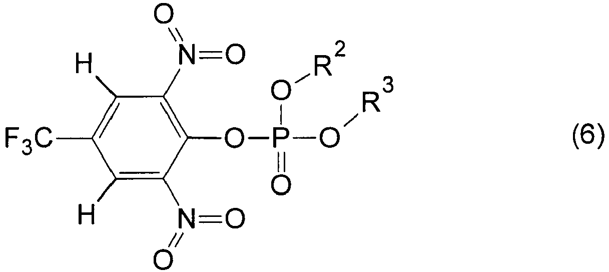 wobei die Reste R² und R³ unabhängig voneinander ausgewählt sind aus dem in der Formel (6) dargestellten Phenylrest, H, CH₃ und CH₂-CH₃, vorzugsweise aus dem Phenylrest, H und CH₃.

Bevorzugte Vertreter der Verbindungen der Formel (6) sind die Verbindungen der folgenden Formeln: 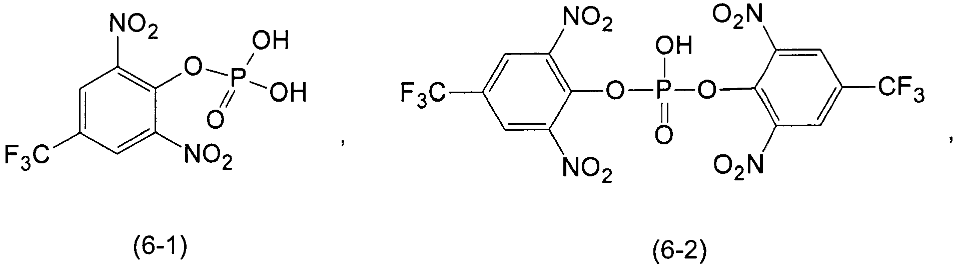 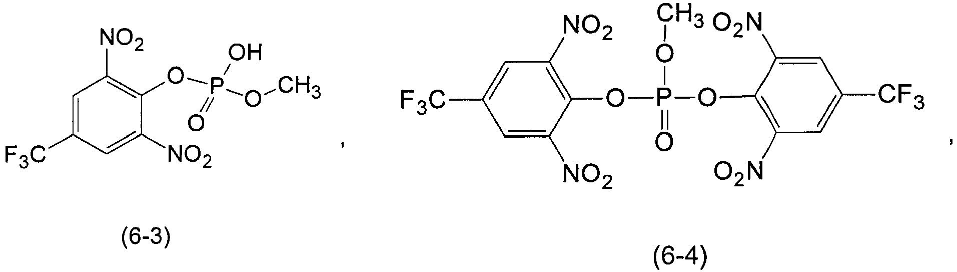 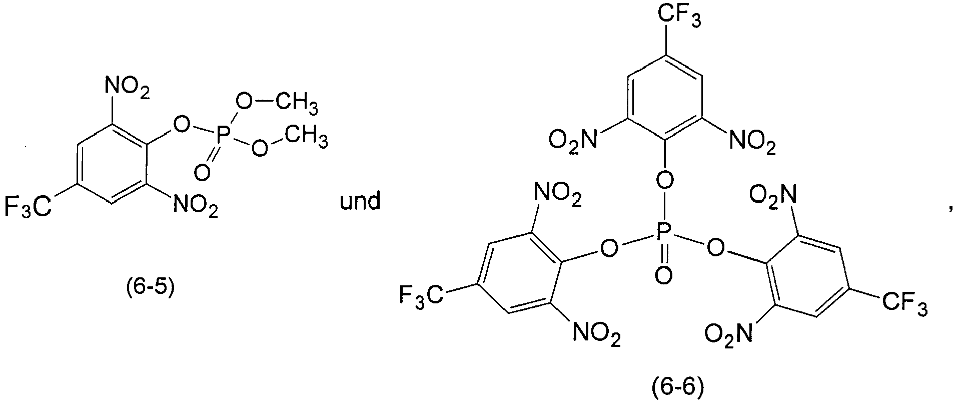 wobei die Verbindung (6-5) als solches nicht von der vorliegenden Erfindung umfasst ist. Die Verwendung der Verbindung (6-5) als Standard bei der ¹H-, ¹³C-, ¹⁵N-, ¹⁹F- oder ³¹P-Kernspinresonanzspektroskopie wie auch ein entsprechendes Kernspinresonanzspektroskopieverfahren und ein Verfahren zur Bestimmung eines Analyts mittels der ¹H-, ¹³C-, ¹⁵N-, ¹⁹F- oder ³¹P-Kernspinresonanzspektroskopie unter Verwendung dieser Verbindung sind jedoch von der vorliegende Erfindung umfasst.

Bei den Verbindungen der Formel (6) zeigen die beiden Wasserstoffatome am Benzolkern eine hohe chemische Verschiebung auf, da sie benachbart (ortho) zu jeweils einer NO₂-Gruppe stehen. Zudem sind sie benachbart zu einer CF₃-Gruppe, so dass ihre Spin-Gitter-Relaxationszeit verringert ist. Da der substituierte Phenylrest in Bezug auf die Anordnung der Substituenten symmetrisch ist erzeugt er in einem ¹H-NMR-Spektrum lediglich ein Singulett. Wenn R² und R³ derselbe substituierte Phenylrest sind, wird die resultierend Verbindung bei Verwendung als ein Standard in der NMR-Spektroskopie in einem ¹H-NMR-Spektrum nur ein Singulett aufzeigen.

Zudem können diese Verbindungen als Standard bei der ¹H-, ¹³C-, ¹⁵N-, ¹⁹F- und ³¹P-Kernspinresonanzspektroskopie verwendet werden.

Verbindungen der Formel (7): 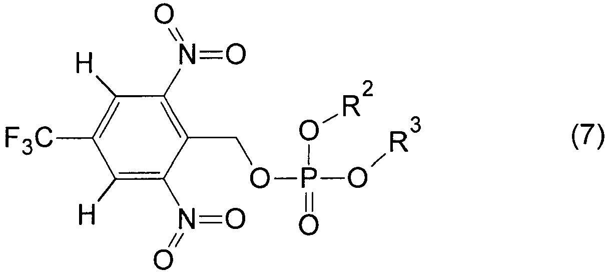 wobei die Reste R² und R³ unabhängig voneinander ausgewählt sind aus dem in der Formel (7) dargestellten Benzylrest, H, CH₃ und CH₂-CH₃, vorzugsweise aus dem Benzylrest, H und CH₃.

Bevorzugte Vertreter der Verbindungen der Formel (7) sind die Verbindungen der folgenden Formeln:

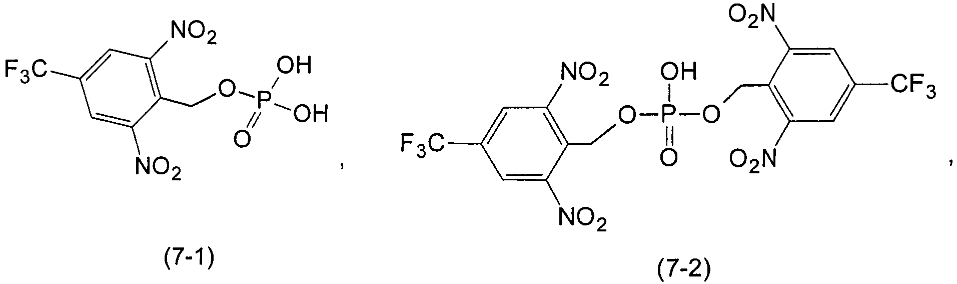

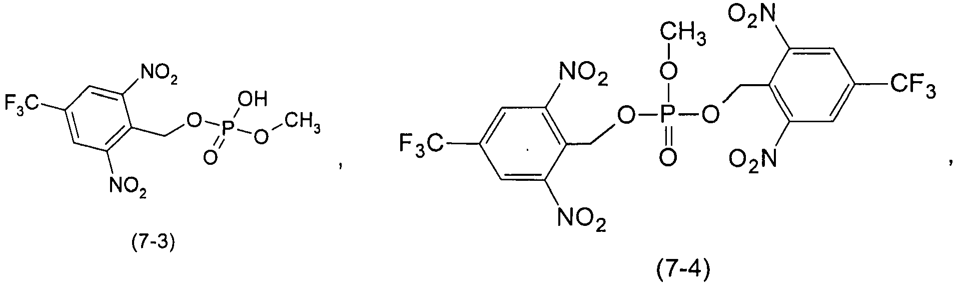

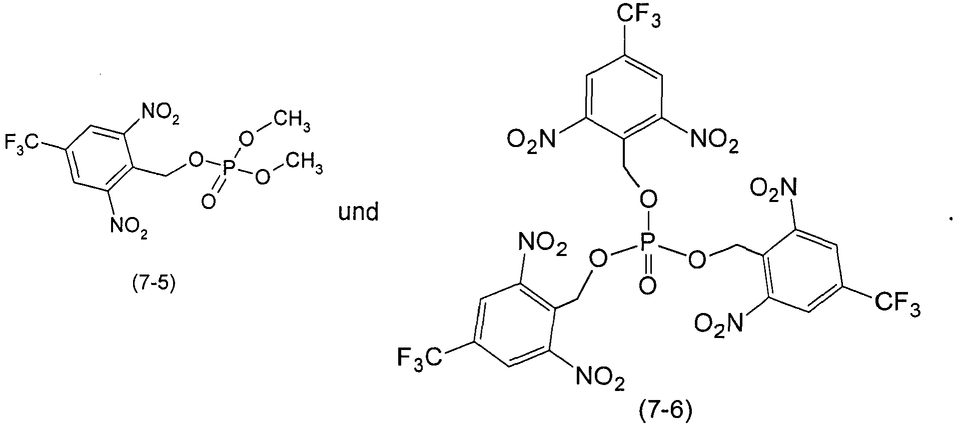

Die Verbindungen der Formel (7) weisen ähnliche Eigenschaften wie die der Formel (6) auf, wobei zusätzlich durch die CH₂-Gruppe des Benzylrests die Spin-Gitter-Relaxationszeit des Phosphoratoms verringert ist.

Verbindungen der Formel (8): 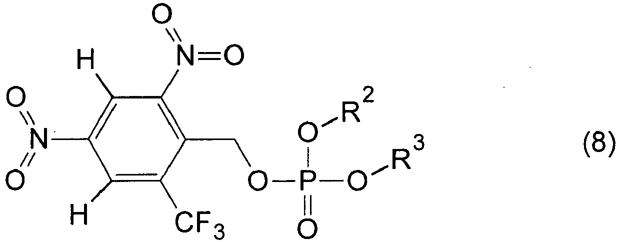 wobei die Reste R² und R³ unabhängig voneinander ausgewählt sind aus dem in der Formel (8) dargestellten Benzylrest, H, CH₃ und CH₂-CH₃, vorzugsweise aus dem Benzylrest, H und CH₃.

Bevorzugte Vertreter der Verbindungen der Formel (8) sind die Verbindungen der folgenden Formeln:

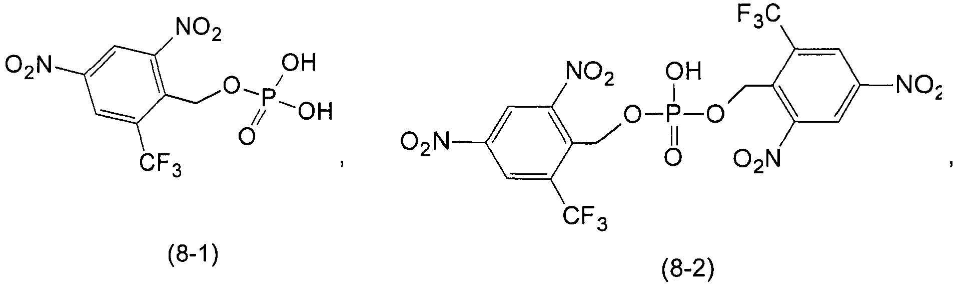

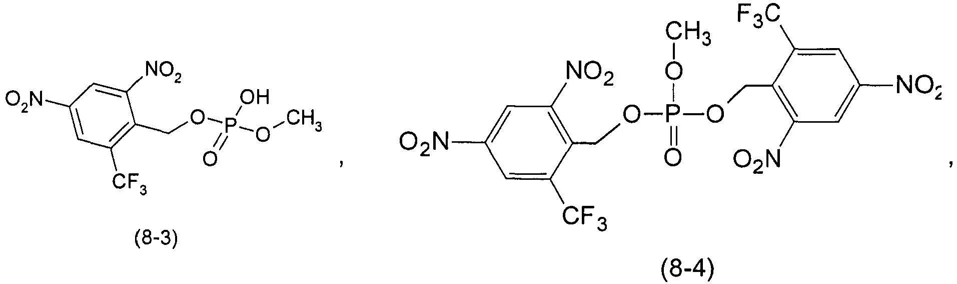

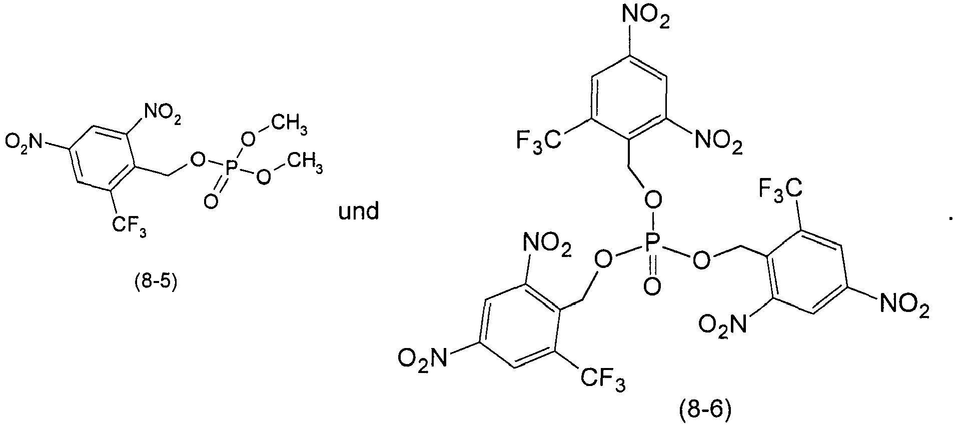

Im Unterschied zu den Verbindungen der Formel (7) zeigen die Verbindungen der Formel (8) in einem ¹H-NMR-Spektrum zwei Singuletts bei einer hohen Verschiebung auf, da der Benzolring nicht symmetrisch substituiert ist. Zudem weisen die beiden aromatischen Wasserstoffatome ähnlich unterschiedliche Spin-Gitter-Relaxationszeiten auf, wie sie oben für die Verbindungen der Formel (3) beschrieben wurden, Sie können daher bei der Verwendung als Standard in der quantitativen NMR-Spektroskopie einen wie oben beschriebenen System-Suitability-Test bereitstellen.

Hergestellt können die erfindungsgemäßen Verbindungen beispielsweise durch die Umsetzung der entsprechenden Phenolverbindungen oder Benzylalkoholverbindungen mit Phosphorsäure (H₃PO₄) bzw. Phosphonsäure (H₃PO₃) oder mit einem reaktiveren Derivat der entsprechenden Säure wie beispielsweise Phosphoroxytrichlorid P(=O)Cl₃. Es können auch andere bekannte Verfahren zur Herstellung von organischen Phosporsäureestern oder Phosponsäureestern verwendet werden. Nachfolgend wird schematisch die Reaktionsgleichung zur Herstellung der Verbindung der Formel (3-6) aufgezeigt:

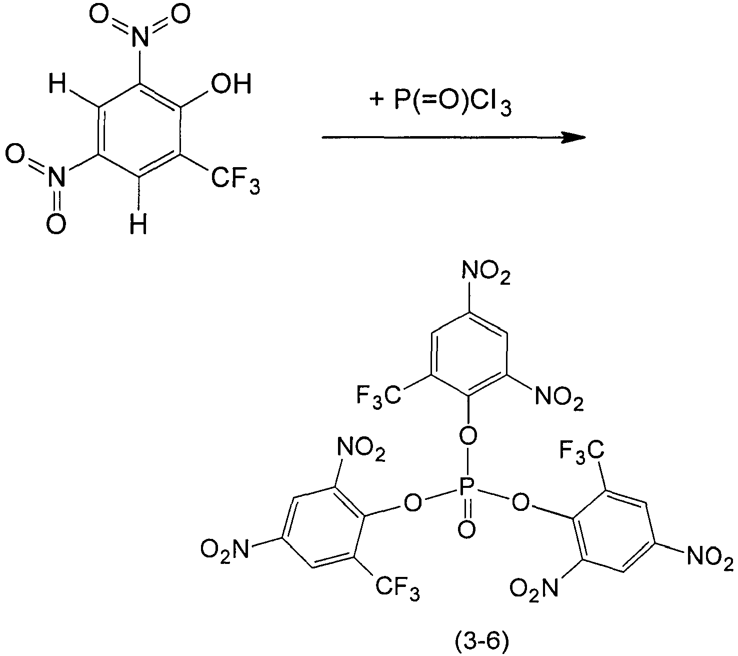

Zusätzlich zu den oben genannten Verbindungen kann auch die Verbindung der folgenden Formel (9) als ein bevorzugter Standard in der NMR-Spektroskopie, vorzugsweise der quantitativen NMR-Spektroskopie verwendet werden:

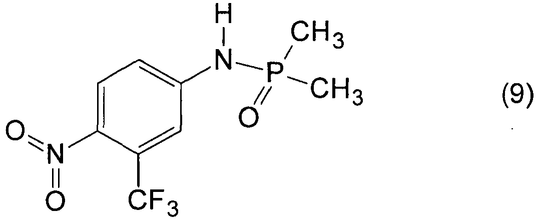

Dies Verbindung enthält neben Kohlenstoffatomen und Wasserstoffatomen auch die Atome N, P und F und kann somit als Standard bei der ¹H-, ¹³C-, ¹⁵N-, ¹⁹F- und ³¹P-Kernspinresonanzspektroskopie verwendet werden. Das ¹H-NMR-Spektrum dieser Verbindung wird bei niedrigem Feld drei verschiedene Signale der drei aromatischen Wasserstoffatome aufzeigen, wobei diese auch unterschiedliche Spin-Gitter-Relaxationszeiten T₁ aufweisen. Somit ist auch diese bevorzugte Verbindung als ein Standard bei der quantitativen NMR-Spektroskopie einsetzbar, der den oben beschriebenen System-Suitability-Test ermöglicht.

In den nachfolgenden Referenzbeispielen wurden ¹H-NMP-Spektren der folgenden Verbindungen gemessen:

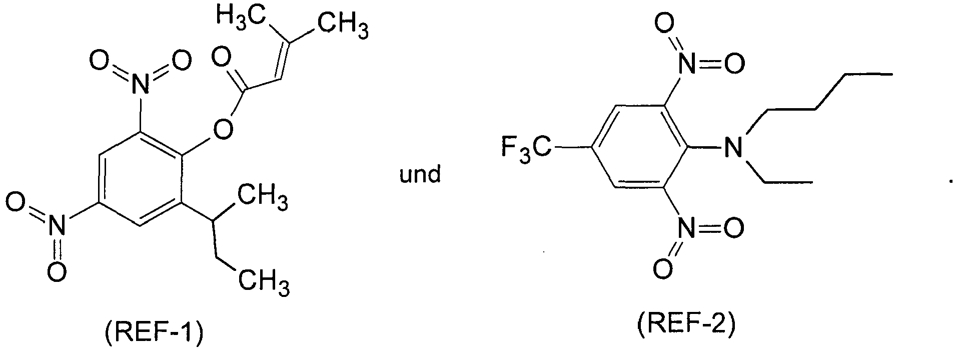

Diese beiden Verbindungen sind nicht von der vorliegenden Erfindung umfasst, zeigen allerdings sehr deutlich, die Effekte der speziellen Anordnung der NO₂- und CF₃-Substituenten am Benzolring.

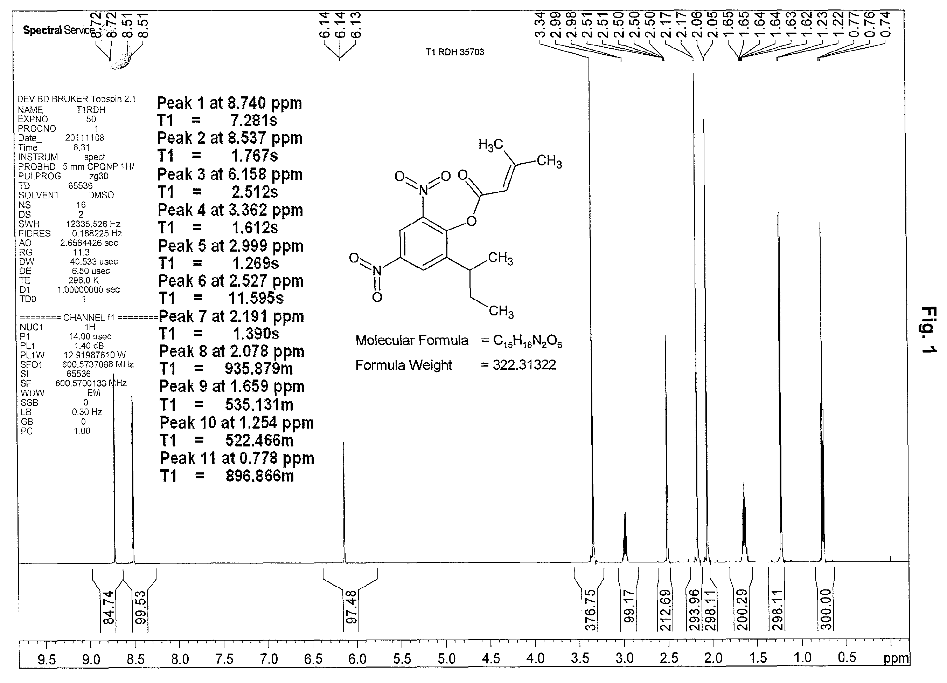

In Fig. 1 ist das ¹H-NMR-Spektrum der Referenzverbindung (REF-1) aufgezeigt. Die beiden aromatischen Wasserstoffatome sind benachbart zu einem bzw. zwei NO₂-Substituenten, so dass deren Signale deutlich oberhalb einer chemischen Verschiebung von 8 erscheinen. Das Wasserstoffatom mit einem benachbarten NO₂-Substituenten erscheint bei δ = 8,5 während das Wasserstoffatom mit zwei benachbarten NO₂-Substituenten noch weiter zu niedrigem Feld verschoben ist und bei δ = 8,7 erscheint. In dem in Fig. 1 gezeigten Spektrum sind darüber hinaus auch die Relaxationszeiten T₁ der verschiedenen Wasserstoffatome der Verbindung aufgeführt. Das Wasserstoffatom mit der höchsten chemischen Verschiebung (δ = 8,7), das keine Dipol-Dipol-Wechselwirkung mit benachbarten Substituenten eingehen kann, weist eine relativ hohe Relaxationszeit T₁ von ungefähr 7,3 s auf. Demgegenüber weist das Wasserstoffatom mit der chemischen Verschiebung von 8,5 eine deutlich geringere Relaxationszeit T₁ von ungefähr 1,8 s auf, da hier eine Dipol-Dipol-Wechselwirkung mit dem benachbarten Alkylsubstituenten stattfindet.

Die beiden aromatischen Wasserstoffatome der Verbindung der Formel (REF-1) weisen deutlich unterschiedliche Spin-Gitter-Relaxationszeiten T₁ auf, so dass diese Verbindung geeignet ist, um den oben beschriebenen System-Suitability-Test zu demonstrieren. In Tabelle 1 sind die relativen Integrale der beiden aromatischen Wasserstoffatome in Abhängigkeit von dem Relaxationsdelay D1 aufgezeigt.

**Tabelle 1:**

| Acquisition Time AQ [s] | Relaxationsdelay D1 [s] | Summe aus AQ und D1 [s] | Integral des Signals bei δ = 8.7 ppm | Integral des Signals bei δ = 8.5 ppm |
|---|---|---|---|---|
| 1,328 | 1 | 2,3 | 79,1 | 100,0 |
| 2,656 | 1 | 3,7 | 84,9 | 100,0 |
| 2,656 | 2 | 4,7 | 87,4 | 100,0 |
| 2,656 | 5 | 7,7 | 92,5 | 100,0 |
| 2,656 | 10 | 12,7 | 97,5 | 100,0 |
| 2,656 | 20 | 22,7 | 99,0 | 100,0 |
| 2,656 | 30 | 32,7 | 100,0 | 100,0 |
| 2,656 | 60 | 62,7 | 100,0 | 100,0 |

Man sieht deutlich, dass bis zu einem Relaxationsdelay von 20 s unterschiedliche Integrale der beiden aromatischen Wasserstoffatome erhalten werden und somit Fehler bei quantitativen Bestimmungen mittels der NMR-Spektroskopie auftreten könnten. Bei Spektren die mit einem Relaxationsdelay von 30 s oder länger aufgenommen wurden, wird man anhand der übereinstimmenden Integrale der beiden aromatischen Wasserstoffatom auf einem Blick erkennen, dass alle Wasserstoffatome mit einer Spin-Gitter-Relaxationszeit von bis zu 7,3 korrekt erfasst wurden.

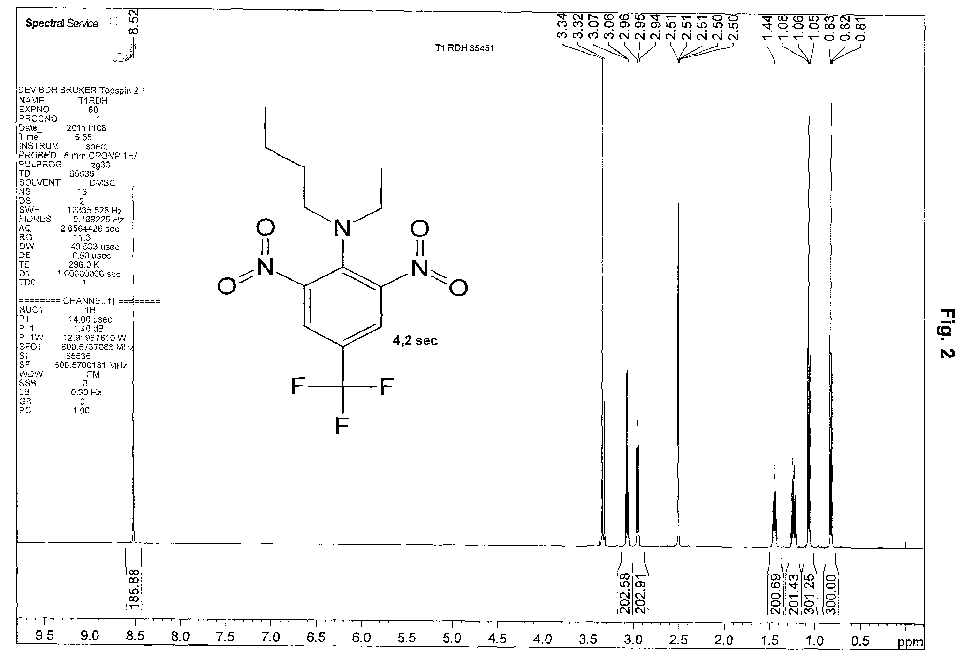

Fig. 2 zeigt das ¹H-NMR-Spektrum der Verbindung (REF-2), d.h. von Benfluralin. Da der Benzolring symmetrisch substituiert ist erscheinen die Signale der beiden aromatischen Wasserstoffatome bei derselben chemischen Verschiebung δ = 8,5. Durch den CF₃-Substituenten wird eine Dipol-Dipol-Wechselwirkung mit den beiden Wasserstoffatomen ermöglicht, so dass deren Spin-Gitter-Relaxationszeit T₁ bei ungefähr 4,2 s liegt.

## Patentansprüche

1. Verwendung einer Verbindung der Formel (1) oder (2) 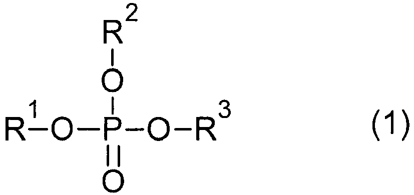 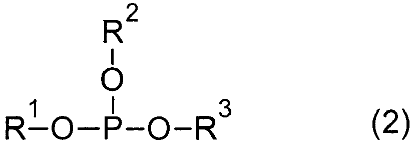
wobei R¹ ein Phenylrest oder Benzylrest ist, dessen Benzolring folgende Substituenten aufweist:
mindestens einen -CF₃-Substituenten,
mindestens einen stickstoffhaltigen Substituenten ausgewählt aus -NO₂ und -NR⁴R⁵, wobei R⁴ und R⁵ unabhängig voneinander ausgewählt sind aus H, CH₃ und CH₂CH₃,
gegebenenfalls einen oder zwei Substituenten ausgewählt aus Cl, Br, I, -CH₃ und -C(=O)OR⁶, wobei R⁶ ausgewählt ist aus H, CH₃ und CH₂CH₃, und mindestens ein Wasserstoffatom, wobei mindestens eines der Wasserstoffatome ortho zu mindestens einem Substituenten steht ausgewählt aus -NO₂ und -C(=O)OR⁶, und
wobei R² und R³ gleich R¹ sind oder unabhängig voneinander ausgewählt sind aus H, CH₃ und CH₂CH₃
als Standard bei der ¹H-, ¹³C-, ¹⁵N-, ¹⁹F- oder ³¹P-Kernspinresonanzspektroskopie.

2. Verwendung nach Anspruch 1, wobei der Benzolring genau zwei Wasserstoffatome als Substituenten trägt.

3. Verwendung nach Anspruch 2, wobei die beiden Wasserstoffatome am Benzolring meta zueinander stehen.

4. Verwendung nach einem der Ansprüche 1 bis 3, wobei mindestens ein Wasserstoffatom am Benzolring ortho zu mindestens einem CF₃-Substituenten oder CH₃-Substituenten steht.

5. Verwendung nach einem der Ansprüche 1 bis 3, wobei mindestens zwei Wasserstoffatome am Benzolring ortho zu mindestens einem CF₃-Substituenten oder CH₃-Substituenten stehen.

6. Verwendung nach einem der Ansprüche 1 bis 5, wobei mindestens zwei Wasserstoffatome am Benzolring ortho zu mindestens einem Substituenten stehen ausgewählt aus -NO₂ und -C(=O)OR⁶.

7. Verwendung nach Anspruch 1, wobei der Benzolring nur ein Wasserstoffatom als Substituenten trägt und das Wasserstoffatom am Benzolring vorzugsweise ortho zu mindestens einem CF₃-Substituenten oder CH₃-Substituenten steht.

8. Verwendung nach einem der vorhergehenden Ansprüche, wobei bei einer ¹H-Kernspinresonanzspektroskopie und unter Festlegung der chemischen Verschiebung von Tetramethylsilan als 0 ppm, die chemische Verschiebung δ von mindestens einem Wasserstoffatom am Benzolring mindestens 8 ppm beträgt.

9. Verwendung nach Anspruch 8, wobei die Spin-Gitter-Relaxationszeit T₁ des mindestens einen Wasserstoffatoms mit der chemischen Verschiebung von mindestens 8 ppm maximal 5 s beträgt.

10. Verwendung nach Anspruch 8, wobei die chemische Verschiebung von zwei Wasserstoffatomen am Benzolring mindestens 8 ppm beträgt und die Relaxationszeiten der beiden Wasserstoffatome sich um mindestens 3 s, vorzugsweise um mindestens 5 s, weiter bevorzugt um mindestens 7 s unterscheiden.

11. Verwendung nach Anspruch 1, wobei die Verbindung ausgewählt ist aus den Verbindungen mit den Formeln (3) bis (8): 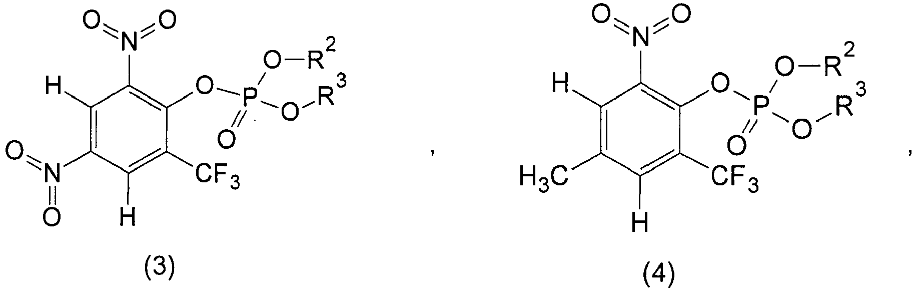 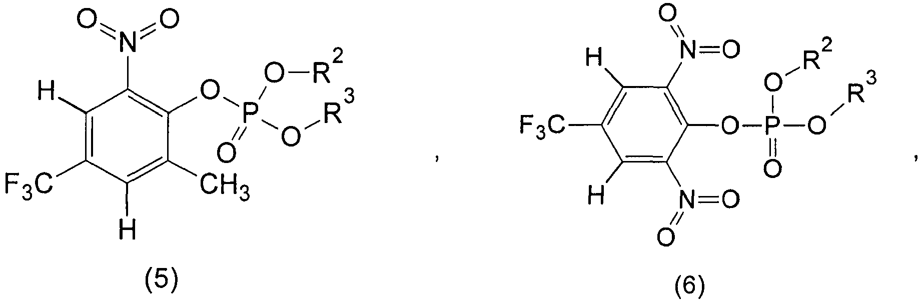 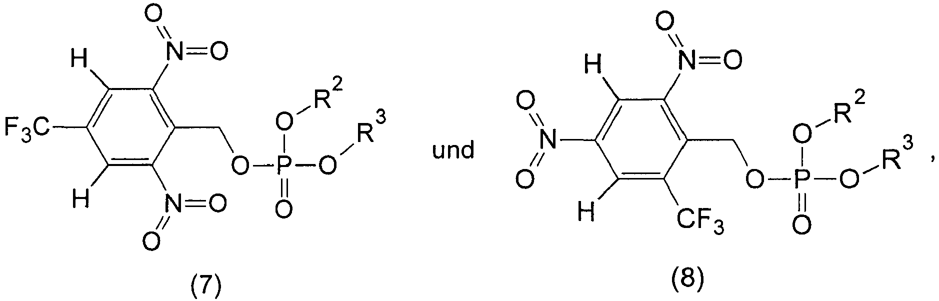 wobei die Reste R² und R³ unabhängig voneinander ausgewählt sind aus dem in den jeweiligen Formeln dargestellten Phenylrest bzw. Benzylrest, H, CH₃ und CH₂-CH₃, vorzugsweise aus dem Phenylrest bzw. Benzylrest, H und CH₃.

12. Verwendung nach Anspruch 11, wobei die Verbindung ausgewählt ist aus den folgenden Verbindungen:

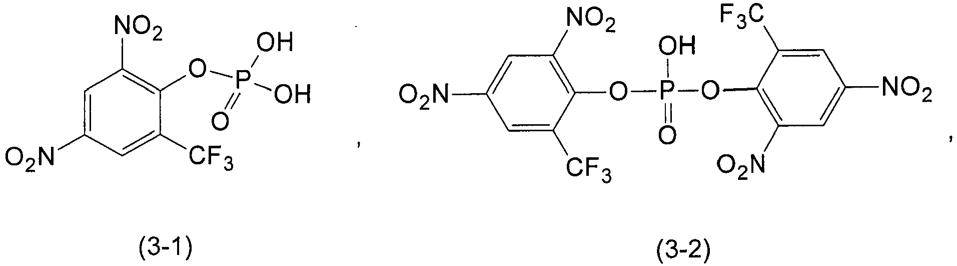

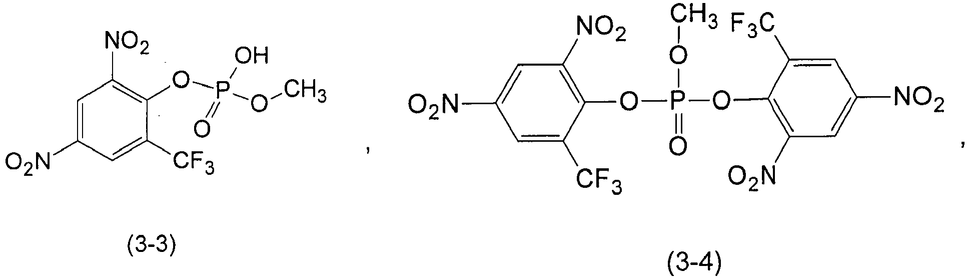

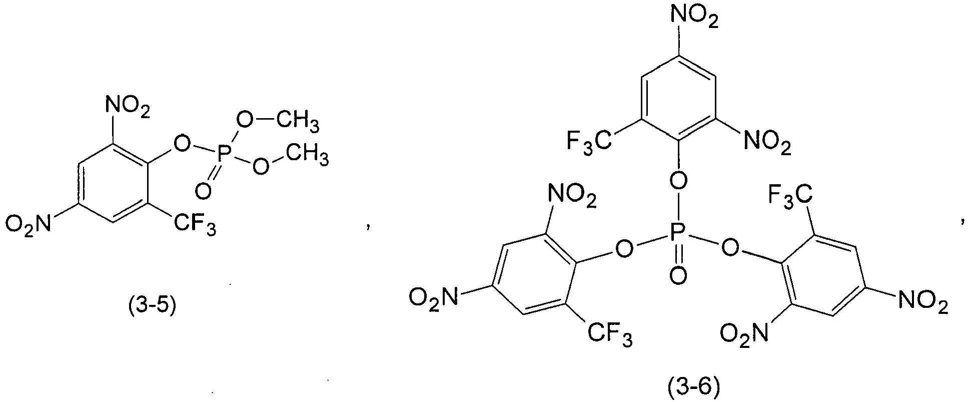

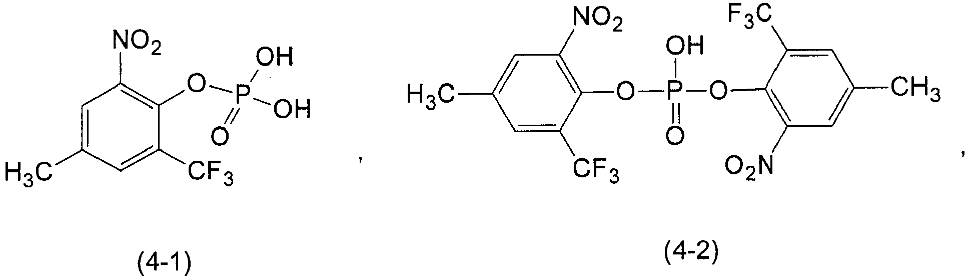

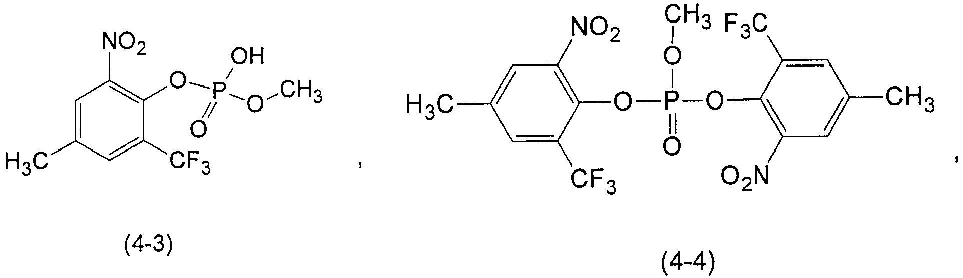

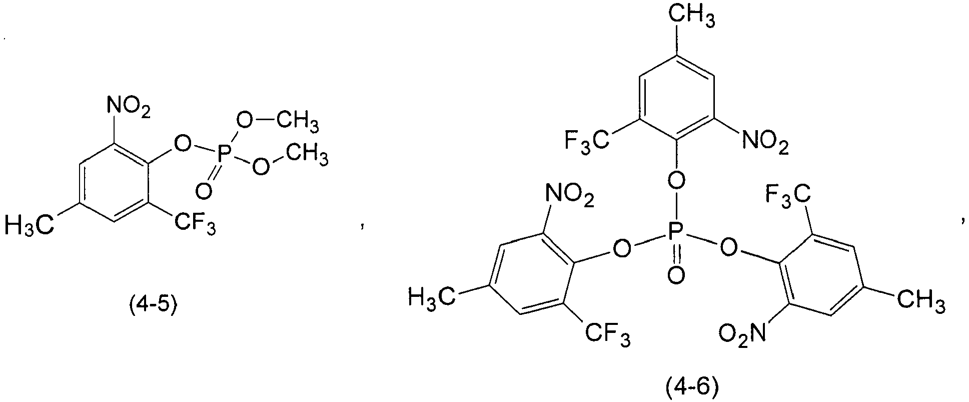

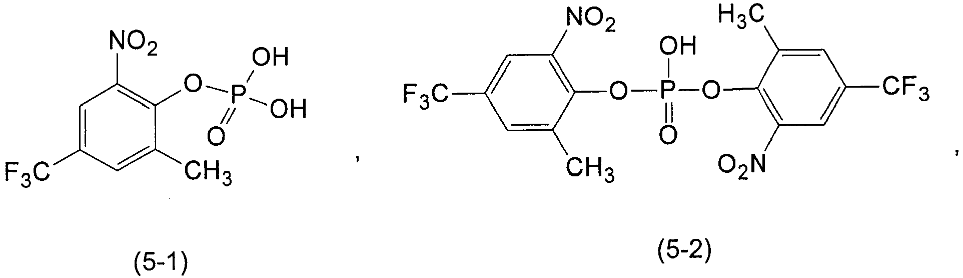

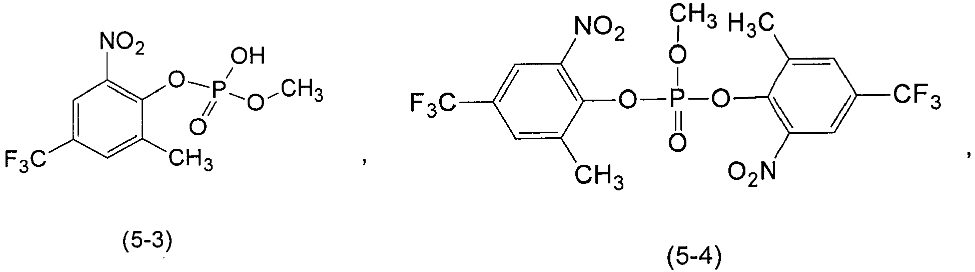

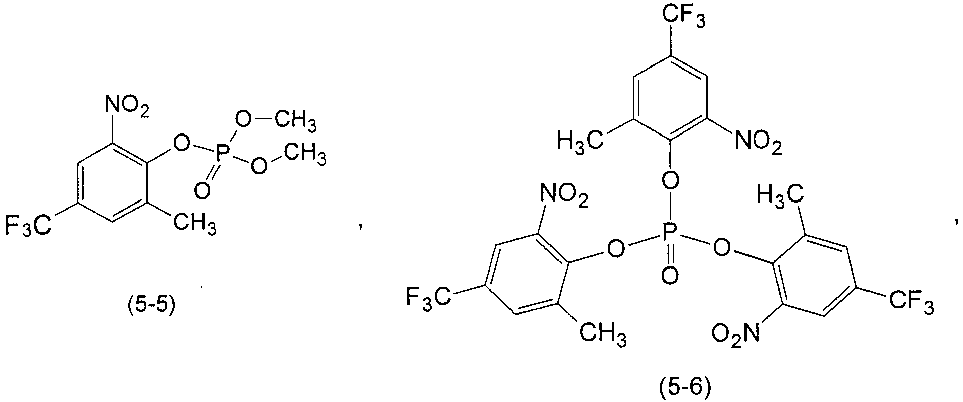

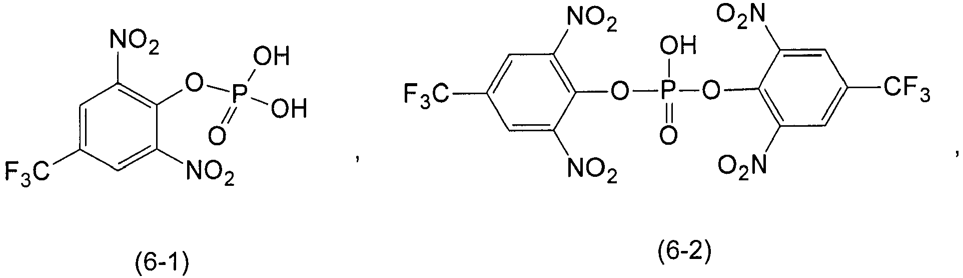

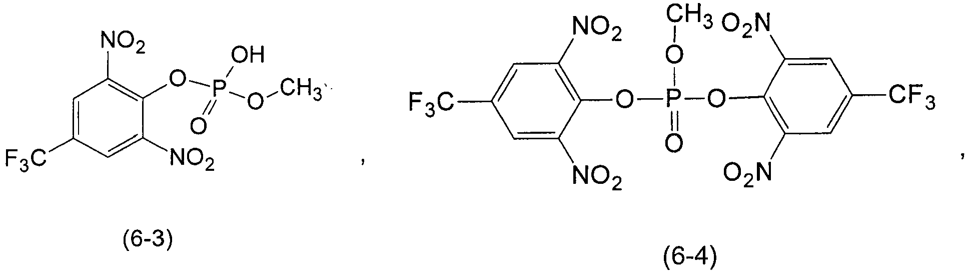

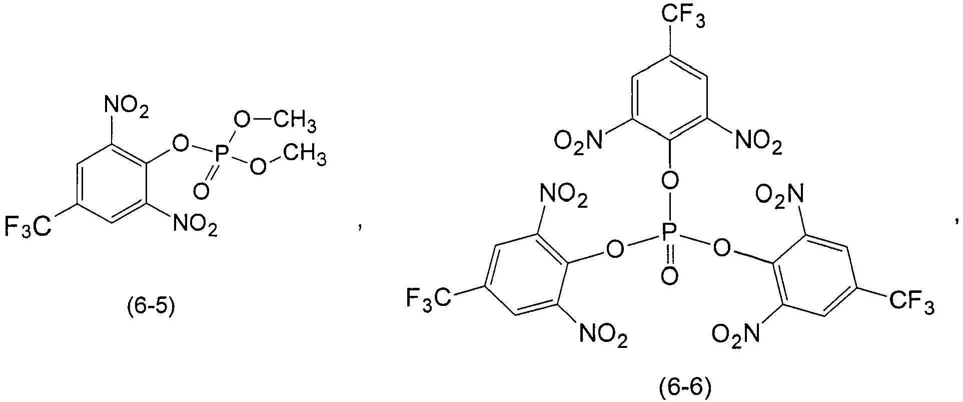

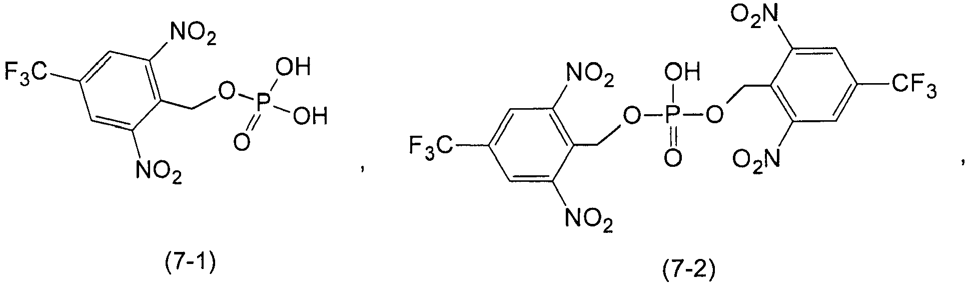

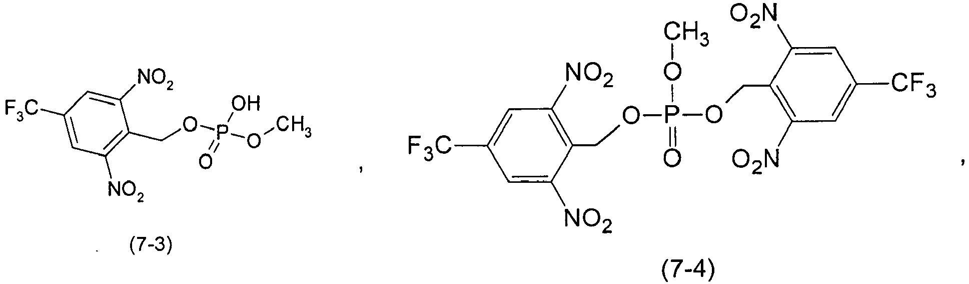

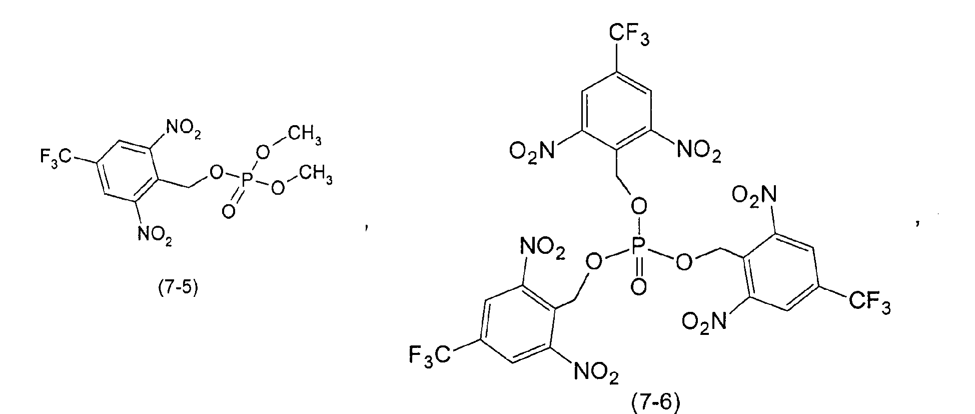

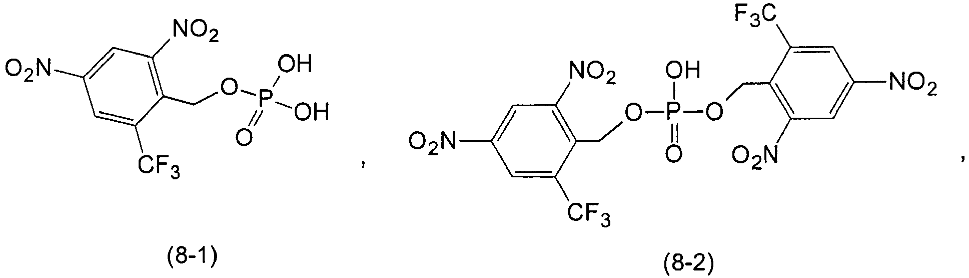

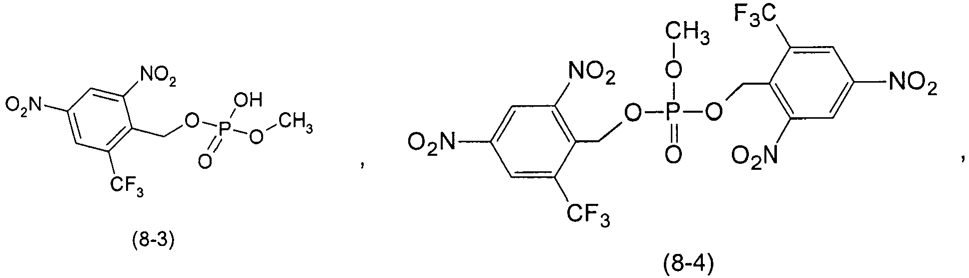

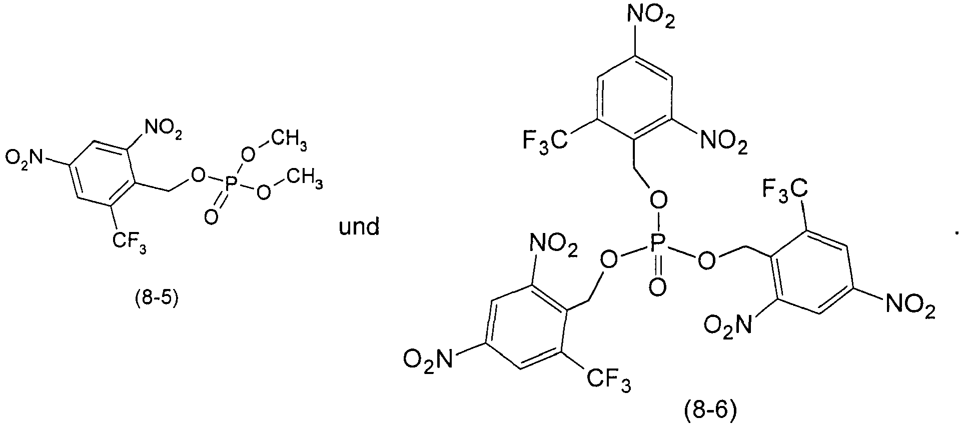

13. Verwendung der Verbindung der Formel (9) 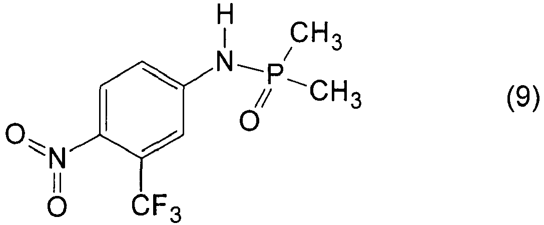 als Standard bei der ¹H-, ¹³C-, ¹⁵N-, ¹⁹F- oder ³¹P-Kernspinresonanzspektroskopie.

14. Kernspinresonanzspektroskopieverfahren, bei dem die Kernspinresonanz von einem der Atome ¹H, ¹³C, ¹⁵N, ¹⁹F oder ³¹P erfasst wird, **dadurch gekennzeichnet, dass** als Standard eine wie in einem der Ansprüche 1 bis 13 definierte Verbindung verwendet wird.

15. Verfahren zur Bestimmung eines Analyts mittels der ¹H-, ¹³C-, ¹⁵N-, ¹⁹F- oder ³¹P-Kernspinresonanzspektroskopie **dadurch gekennzeichnet, dass** als Standard eine wie in einem der Ansprüche 1 bis 13 definierte Verbindung verwendet wird.

16. Verbindung der Formel (1), (2) oder (9) wie in einem der Ansprüche 1 bis 13 definiert mit Ausnahme der folgenden Verbindungen: 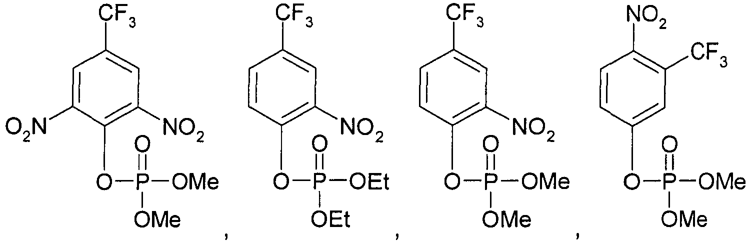 und

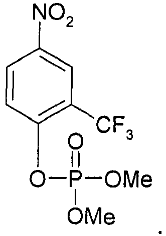

17. NMR-Standard enthaltend eine Verbindung der Formel (1), (2) oder (9) wie in einem der Ansprüche 1 bis 13 definiert mit Ausnahme der folgenden Verbindungen: 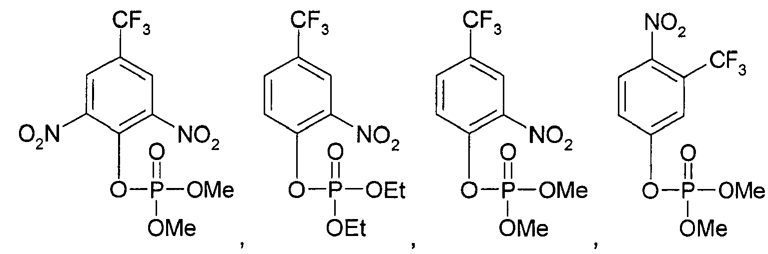 und

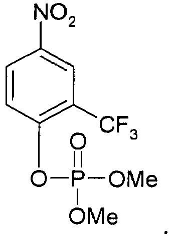

## Claims

1. Use of a compound of formula (1) or (2) 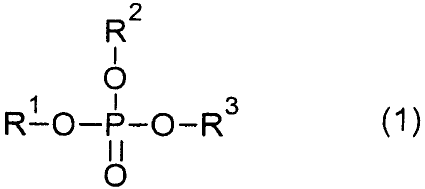 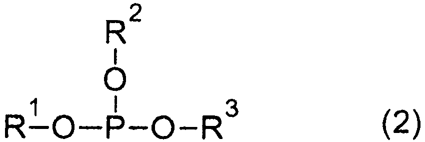
where R¹ is a phenyl group or benzyl group, the benzene ring of which has the following substituents:
at least one -CF₃ substituent,
at least one nitrogen-containing substituent selected from -NO₂ and -NR⁴R⁵, where R⁴ and R⁵ are selected independently of one another from H, CH₃ and CH₂CH₃, optionally one or two substituents selected from Cl, Br, I, -CH₃, and -C(=O)OR⁶, where R⁶ is selected from H, CH₃, and CH₂CH₃, and
at least one hydrogen atom, where at least one of the hydrogen atoms is ortho to at least one substituent selected from -NO₂ and -C(=O)OR⁶, and
where R² and R³ are the same as R¹ or are selected independently of one another from H, CH₃, and CH₂CH₃,
as a standard in ¹H-, ¹³C-, ¹⁵N-, ¹⁹F-, or ³¹P- nuclear magnetic resonance spectroscopy.

2. Use according to claim 1, wherein the benzene ring carries precisely two hydrogen atoms as substituents.

3. Use according to claim 2, wherein the two hydrogen atoms are meta to one another on the benzene ring.

4. Use according to any one of claims 1 to 3, wherein at least one hydrogen atom on the benzene ring is ortho to at least one CF₃ substituent or CH₃ substituent.

5. Use according to any one of claims 1 to 3, wherein at least two hydrogen atoms on the benzene ring are ortho to at least one CF₃ substituent or CH₃ substituent.

6. Use according to any one of claims 1 to 5, wherein at least two hydrogen atoms on the benzene ring are ortho to at least one substituent selected from -NO₂ and -C(=O)OR⁶.

7. Use according to claim 1, wherein the benzene ring carries only one hydrogen atom as the substituent, and the hydrogen atom on the benzene ring is preferably ortho to at least one CF₃ substituent or CH₃ substituent.

8. Use according to any one of the preceding claims, wherein, in a ¹H nuclear magnetic resonance spectroscopy, having the chemical shift of tetramethylsilane set as 0 ppm, the chemical shift δ of at least one hydrogen atom on the benzene ring is at least 8 ppm.

9. Use according to claim 8, wherein the spin-lattice relaxation time T₁ of the at least one hydrogen atom having the chemical shift of at least 8 ppm is not more than 5 s.

10. Use according to claim 8, wherein the chemical shift of two hydrogen atoms on the benzene ring is at least 8 ppm, and the relaxation times of the two hydrogen atoms differ by at least 3 s, preferably by at least 5 s, more preferably by at least 7 s.

11. Use according to claim 1, wherein the compound is selected from the compounds of formulae (3) to (8): 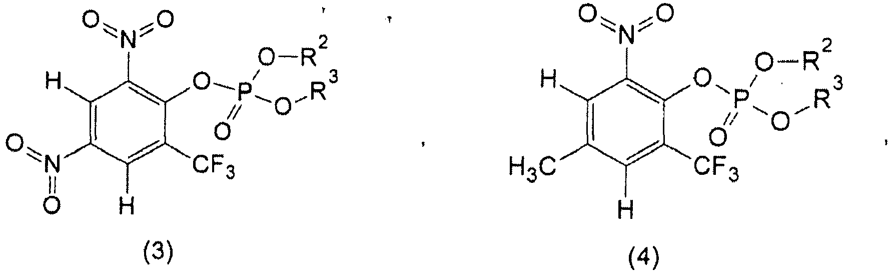 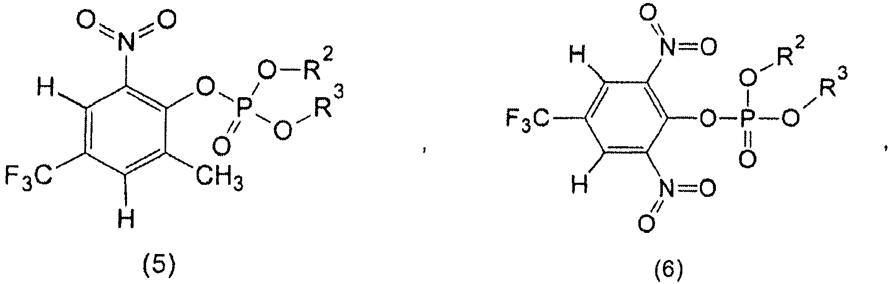 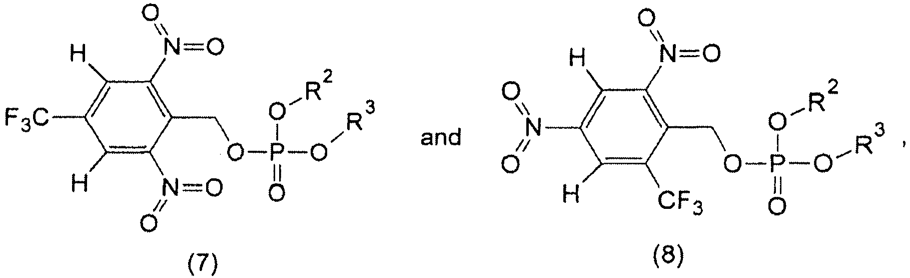 wherein the groups R² and R³ are selected independently of one another from the phenyl group or benzyl group shown in the respective formulae, H, CH₃ and CH₂-CH₃, preferably from the phenyl group or benzyl group, H and CH₃.

12. Use according to claim 11, wherein the compound is selected from the following compounds:

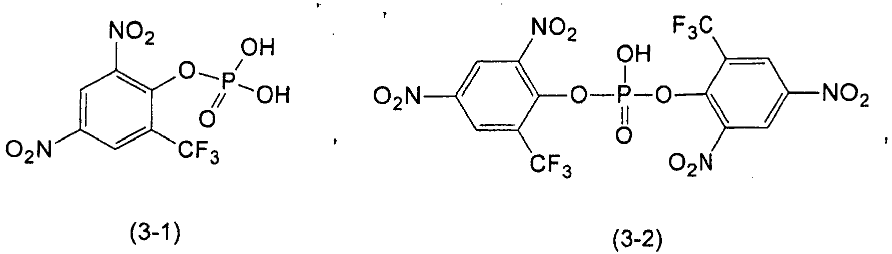

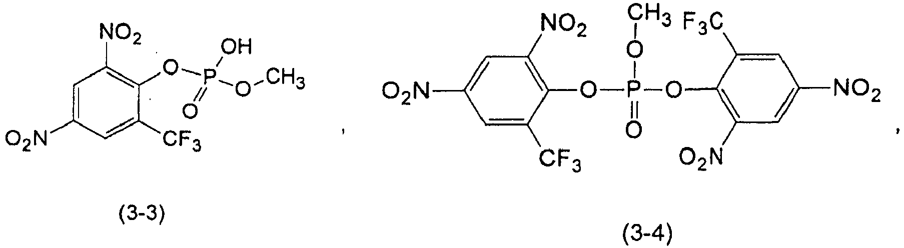

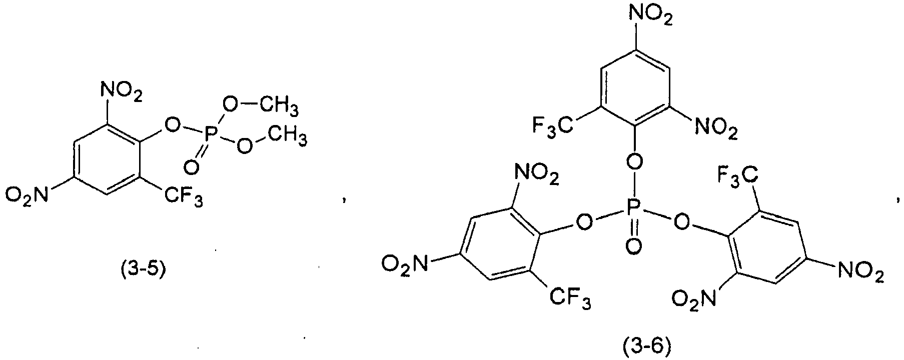

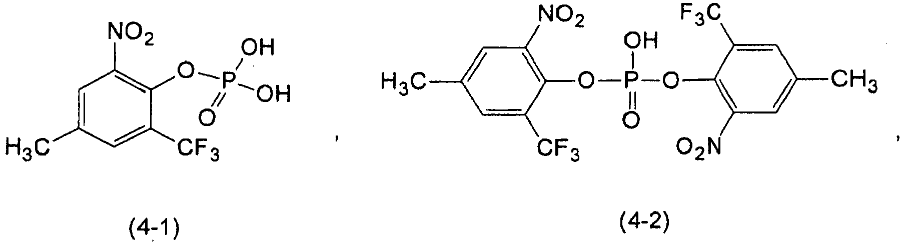

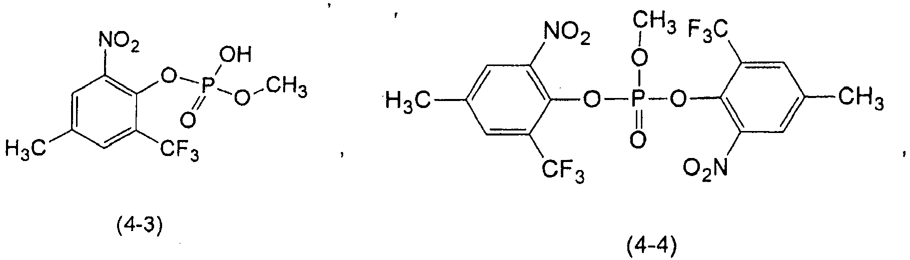

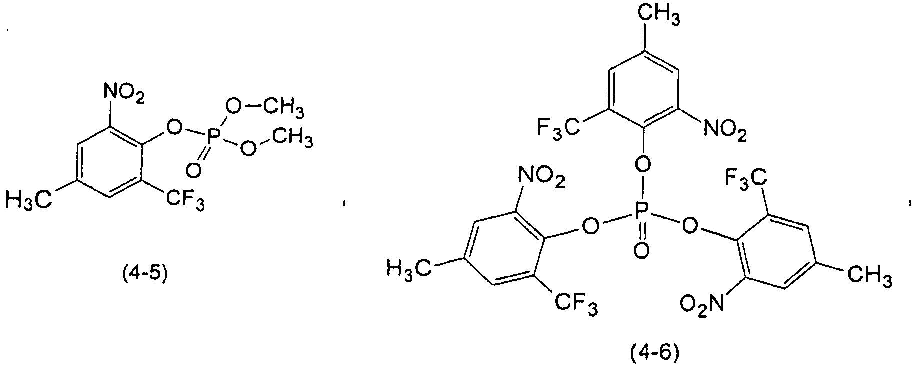

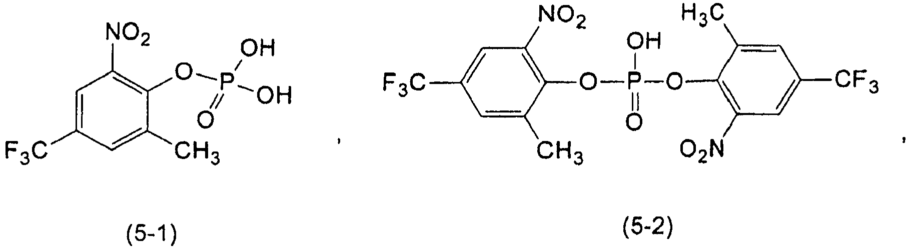

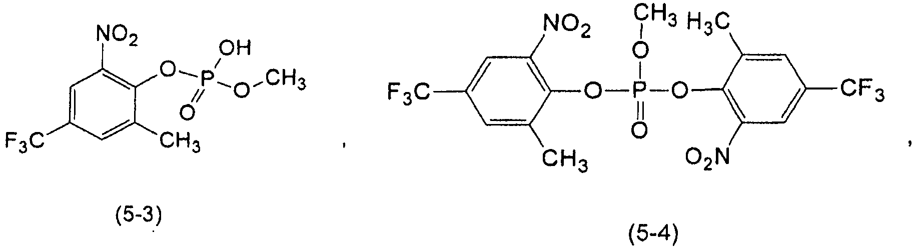

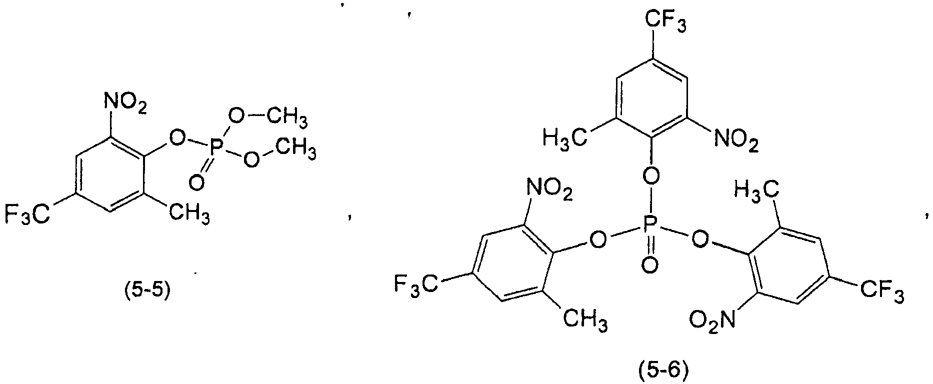

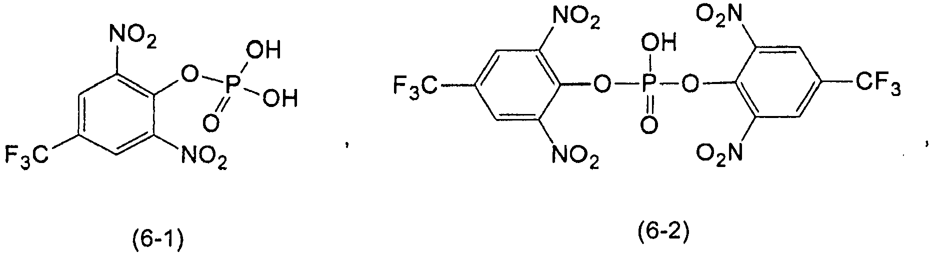

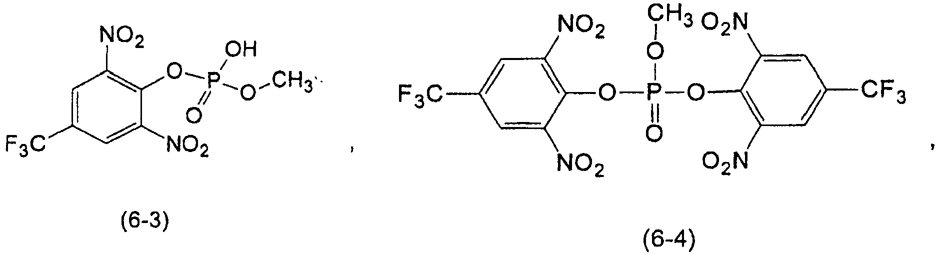

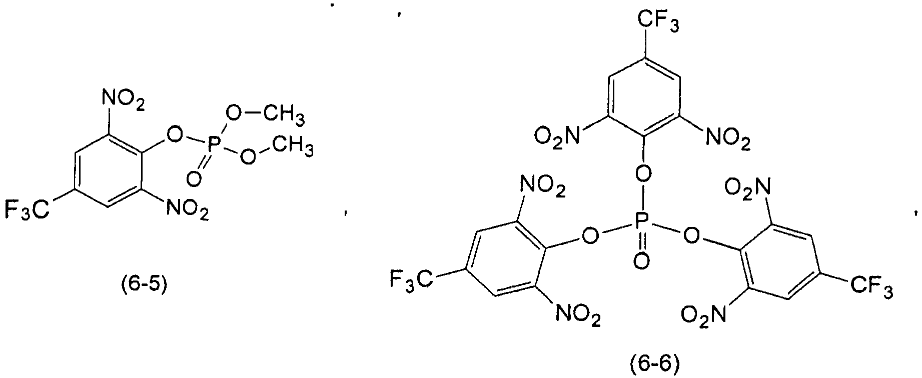

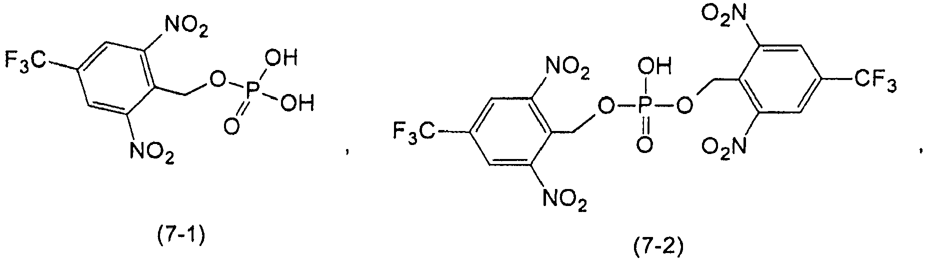

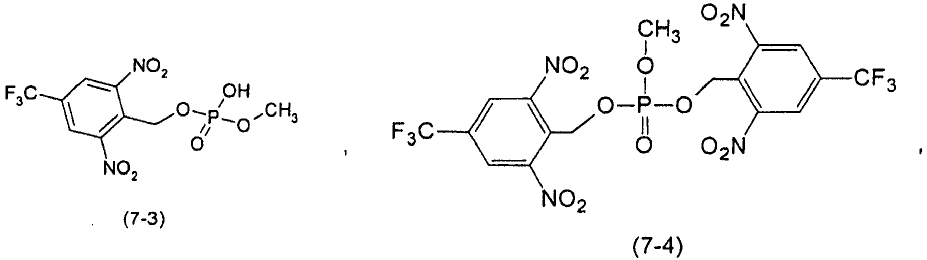

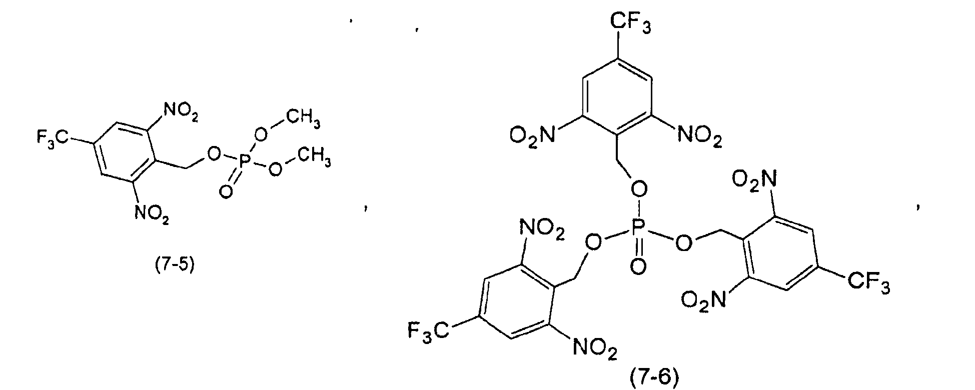

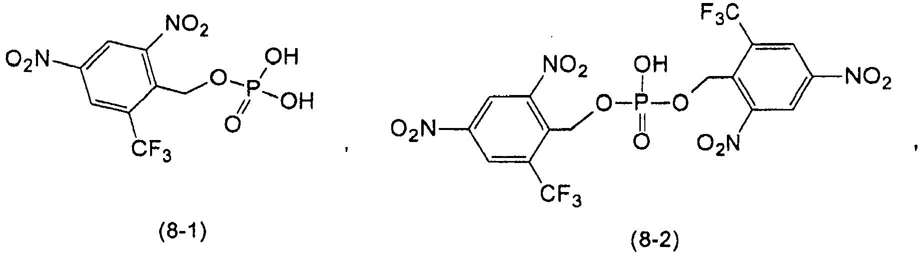

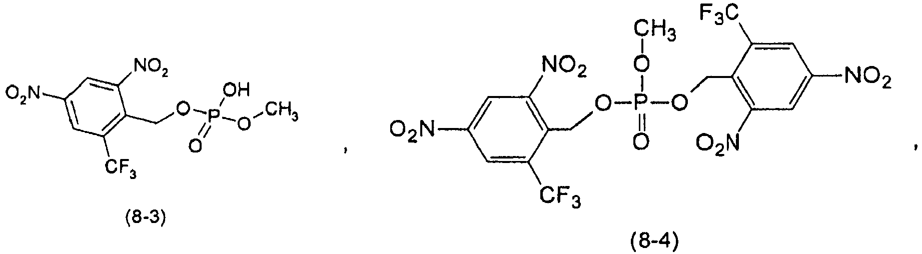

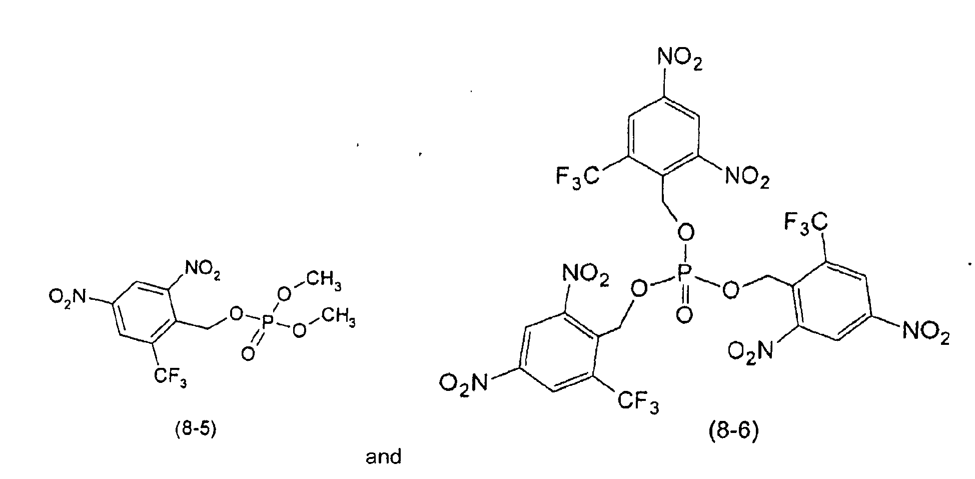

13. Use of the compound of formula (9) 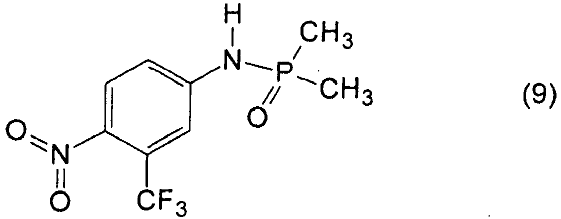 as a standard in ¹H-, ¹³C-, ¹⁵N-, ¹⁹F- or ³¹P- nuclear magnetic resonance spectroscopy.

14. Nuclear magnetic resonance spectroscopy method in which the nuclear magnetic resonance of one of the atoms ¹H, ¹³C, ¹⁵N, ¹⁹F, or ³¹P is detected, **characterised in that** a compound as defined in anyone of claims 1 to 13 is used as the standard.

15. Method for determining an analyte by means of ¹H-, ¹³C-, ¹⁵N-, ¹⁹F-, or ³¹P- nuclear magnetic resonance spectroscopy, **characterised in that** a compound as defined in any one of claims 1 to 13 is used as the standard.

16. Compound of formula (1), (2), or (9) as defined in any one of claims 1 to 13, with the exception of the following compounds: 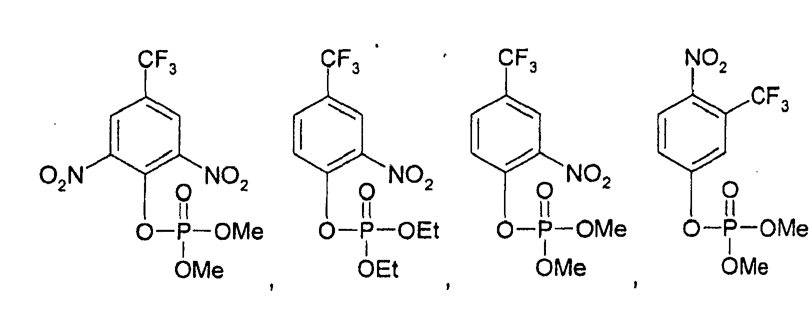 and

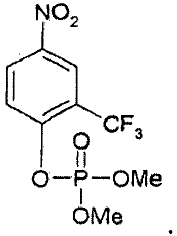

17. NMR standard comprising a compound of formula (1), (2) or (9) as defined in any one of claims 1 to 13, with the exception of the following compounds: 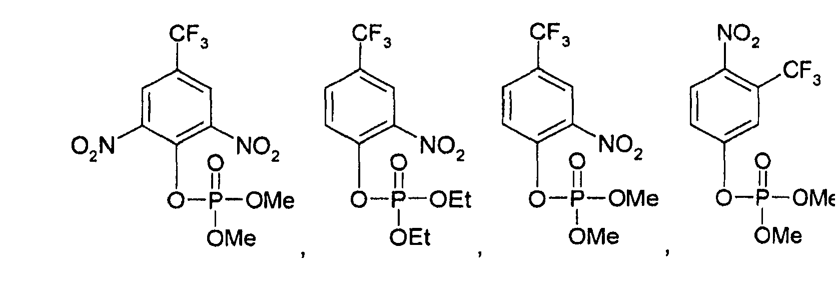 and

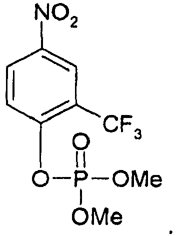

## Revendications

1. Utilisation d'un composé de la formule (1) ou (2), 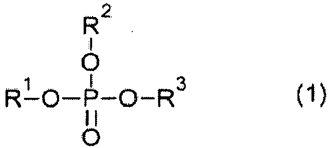 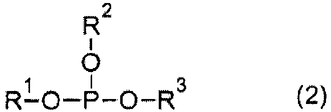
dans laquelle R¹ est un radical phényle ou un radical benzyle, dont le cycle benzène présente des substituants qui suivent :
au moins un substituant -CF₃,
au moins un substituant contenant de l'azote choisi parmi -NO₂ et -NR⁴R⁵, dans laquelle R⁴ et R⁵ sont choisis indépendamment l'un de l'autre parmi H, CH₃ et CH₂CH₃,
éventuellement un ou deux substituants choisis parmi Cl, Br, I, -CH₃ et -C(=O)OR⁶, dans laquelle R⁶ est choisi parmi H, CH₃ et CH₂CH₃, et au moins un atome d'hydrogène, dans laquelle au moins un des atomes d'hydrogène se trouve en position ortho par rapport au moins à un substituant choisi parmi -NO₂ et -C(=O)OR⁶, et
dans laquelle R² et R³ sont identiques à R¹ ou sont choisis indépendamment l'un de l'autre parmi H, CH₃ et CH₂CH₃
en tant que norme pour la spectroscopie par résonance magnétique nucléaire à ¹H, ¹³C, ¹⁵N, ¹⁹F ou ³¹P.

2. Utilisation selon la revendication 1, dans laquelle le cycle de benzène supporte précisément deux atomes d'hydrogène en tant que substituants.

3. Utilisation selon la revendication 2, dans laquelle les deux atomes d'hydrogène au niveau du cycle de benzène se trouvent en position méta l'un par rapport à l'autre.

4. Utilisation selon l'une quelconque des revendications 1 à 3, dans laquelle au moins un atome d'hydrogène au niveau du cycle de benzène se trouve en position ortho par rapport au moins à un substituant CF₃ ou à un substituant CH₃.

5. Utilisation selon l'une quelconque des revendications 1 à 3, dans laquelle au moins deux atomes d'hydrogène au niveau du cycle de benzène se trouvent en position ortho par rapport au moins à un substituant CF₃ ou à un substituant CH₃.

6. Utilisation selon l'une quelconque des revendications 1 à 5, dans laquelle au moins deux atomes d'hydrogène au niveau du cycle de benzène sont situés en position ortho par rapport au moins à un substituant choisi parmi -NO₂ et -C(=O)OR⁶.

7. Utilisation selon la revendication 1, dans laquelle le cycle de benzène ne supporte qu'un atome d'hydrogène en tant que substituant et que l'atome d'hydrogène au niveau du cycle de benzène se trouve de préférence en position ortho par rapport au moins à un substituant CF₃ ou à un substituant CH₃.

8. Utilisation selon l'une quelconque des revendications précédentes, dans laquelle dans le cas d'une spectroscopie par résonance magnétique nucléaire ¹H et en fixant le décalage chimique du tétraméthylsilane en tant que 0 ppm, le décalage chimique δ d'au moins un atome d'hydrogène au niveau du cycle de benzène est d'au moins 8 ppm.

9. Utilisation selon la revendication 8, dans laquelle le temps de relaxation spin-réseau T₁ de l'au moins un atome d'hydrogène avec le décalage chimique d'au moins 8 ppm est de 5 s au maximum.

10. Utilisation selon la revendication 8, dans laquelle le décalage chimique de deux atomes d'hydrogène au niveau du cycle de benzène est d'au moins 8 ppm et que les temps de relaxation des deux atomes d'hydrogène sont différents d'au moins 3 s, de préférence d'au moins 5 s, de manière davantage préférée d'au moins 7 s.

11. Utilisation selon la revendication 1, dans laquelle le composé est choisi parmi les composés présentant les formules (3) à (8) : 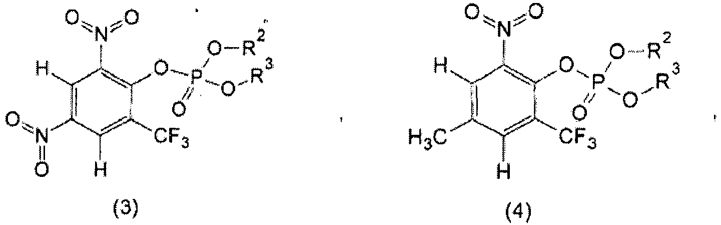 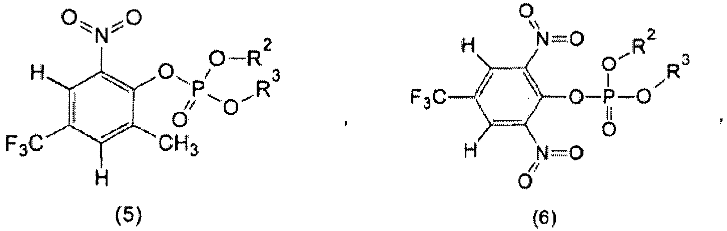 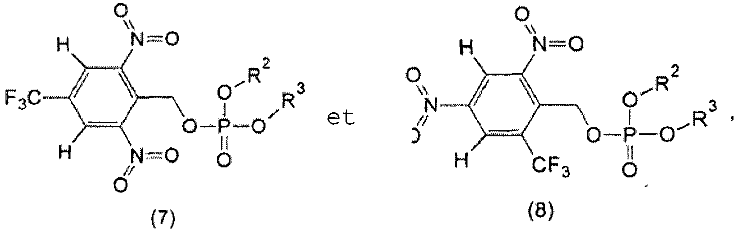 dans laquelle les radicaux R² et R³ sont choisis indépendamment l'un de l'autre parmi le radical phényle ou le radical benzyle illustré dans les formules respectives, H, CH₃ et CH₂-CH₃, de préférence parmi le radical de phényle ou le radical de benzyle, H et CH₃.

12. Utilisation selon la revendication 11, dans laquelle le composé est choisi parmi les composés suivants :

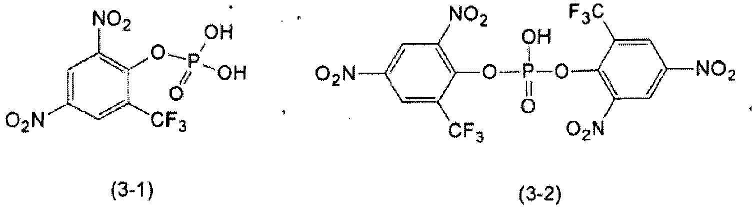

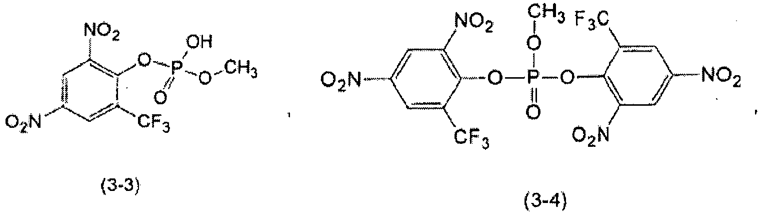

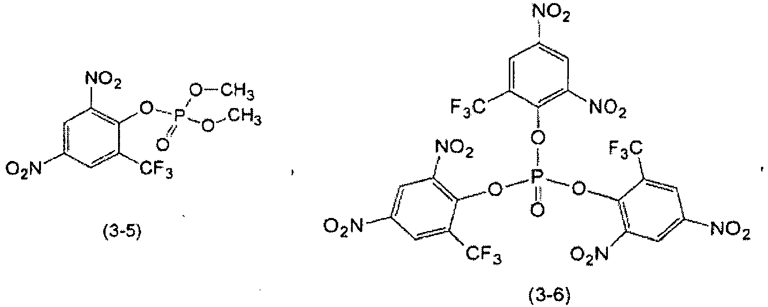

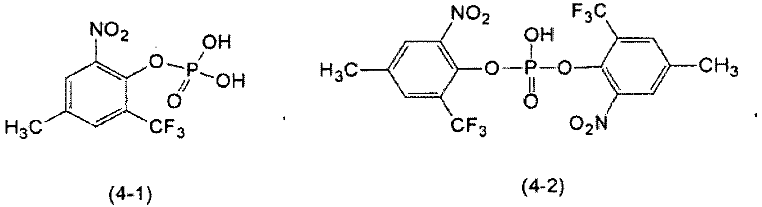

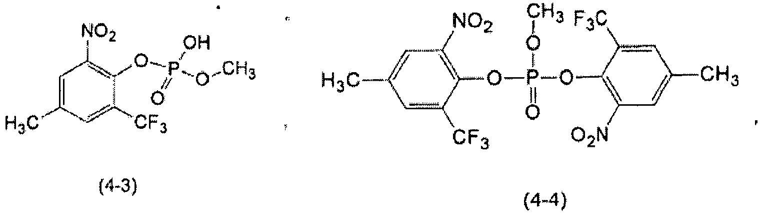

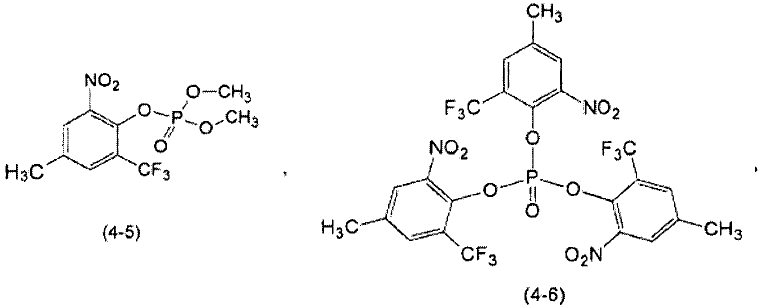

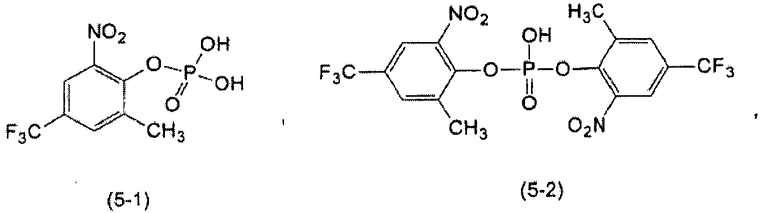

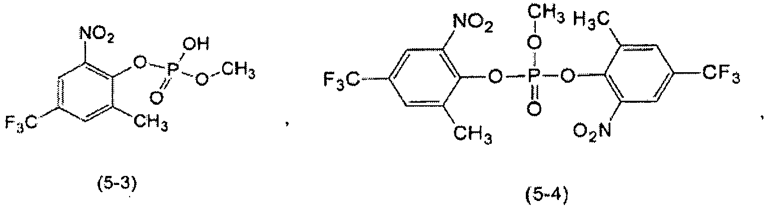

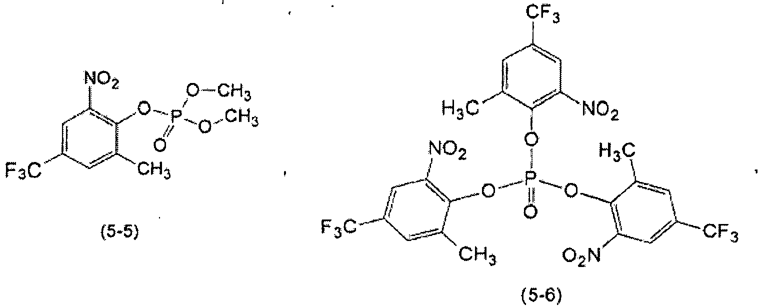

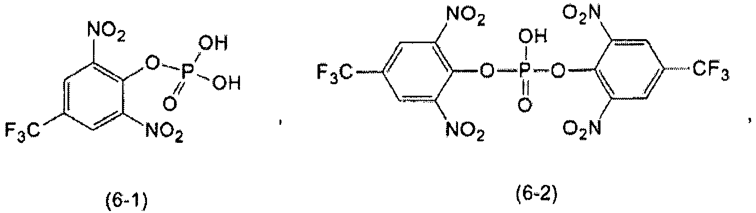

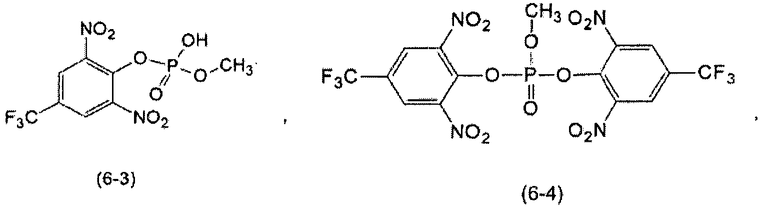

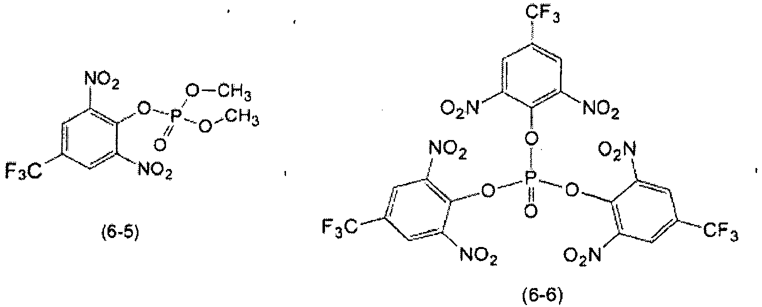

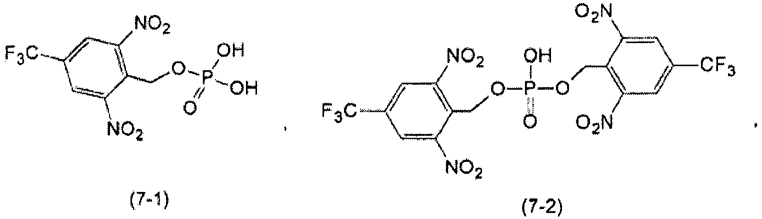

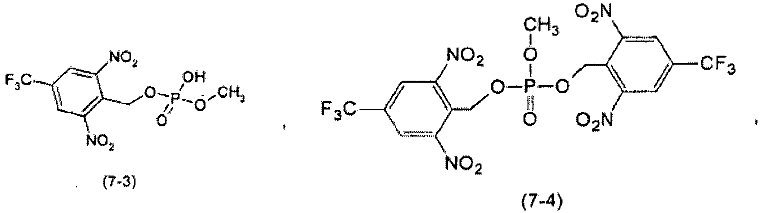

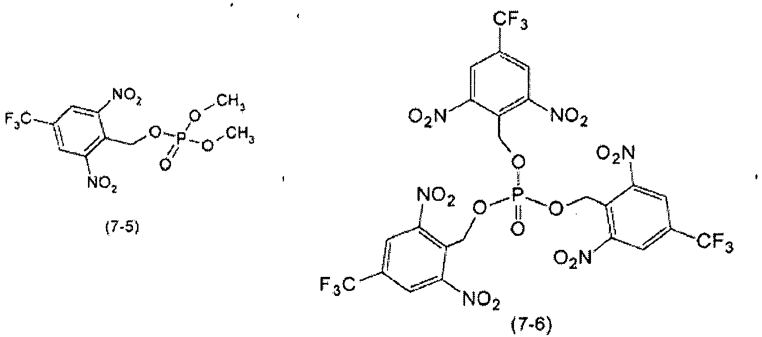

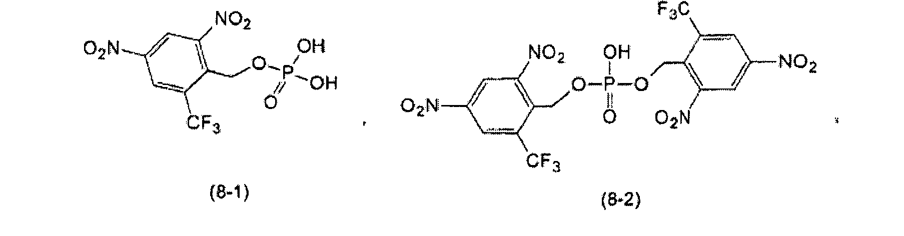

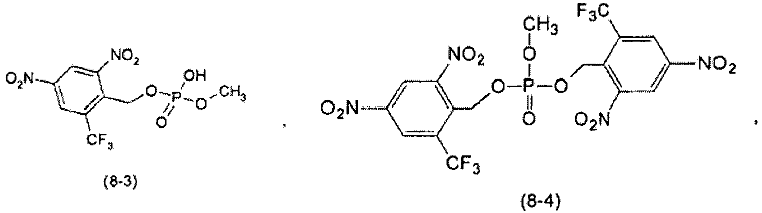

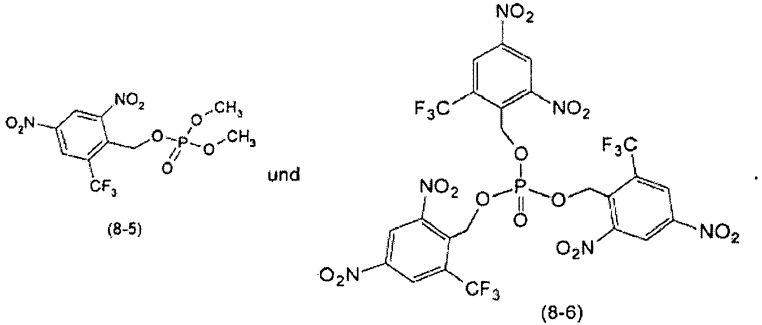

13. Utilisation du composé de la formule (9) 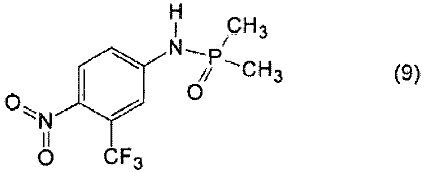 en tant que norme pour la spectroscopie par résonance magnétique nucléaire à ¹H, ¹³C, ¹⁵N, ¹⁹F ou ³¹P.

14. Procédé de spectroscopie par résonance magnétique nucléaire, dans le cadre duquel la résonance magnétique nucléaire est détectée par un des atomes ¹H, ¹³C, ¹⁵N, ¹⁹F ou ³¹P, **caractérisé en ce qu'**un composé tel que défini dans l'une quelconque des revendications 1 à 13 est utilisé en tant que norme.

15. Procédé servant à déterminer un analyte au moyen de la spectroscopie par résonance magnétique nucléaire à ¹H, ¹³C, ¹⁵N, ¹⁹F ou ³¹P, **caractérisé en ce qu'**un composé tel que défini dans l'une quelconque des revendications 1 à 13 est utilisé en tant que norme.

16. Composé de la formule (1), (2), ou (9) tel que défini dans l'une quelconque des revendications 1 à 13, à l'exception des composés qui suivent : 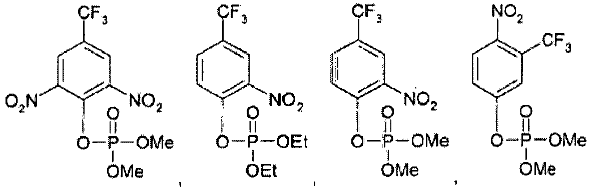 et

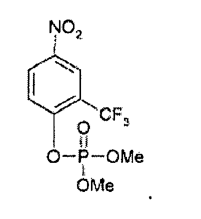

17. Norme NMR contenant un composé de la formule (1), (2), ou (9) tel que défini dans l'une quelconque des revendications 1 à 13 à l'exception des composés qui suivent : 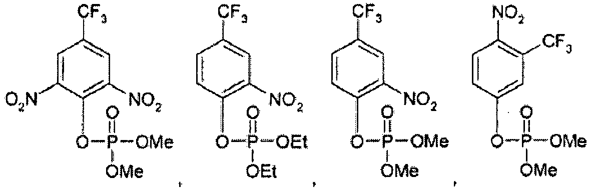 et
